# EUROPÄISCHE PATENTSCHRIFT

(11) **EP 2 820 768 B1**
(45) Veröffentlichungstag und Bekanntmachung des Hinweises auf die Patenterteilung: **13.02.2019**
(21) Anmeldenummer: 13705808.7
(22) Anmeldetag: 25.02.2013
(51) Int. Cl.: H04B 5/00, G06K 19/077, B42D 25/305, B42D 25/455, B42D 25/46

(54) **KONTAKTLOSE DATENÜBERTRAGUNGSEINRICHTUNG, DIESE ENTHALTENDES SICHERHEITS- UND/ODER WERTDOKUMENT UND VERFAHREN ZUR HERSTELLUNG DER KONTAKTLOSEN DATENÜBERTRAGUNGSEINRICHTUNG**
CONTACTLESS DATA-TRANSMITTING DEVICE, SECURITY AND/OR VALUE DOCUMENT CONTAINING SAID DATA-TRANSMITTING DEVICE, AND METHOD FOR PRODUCING THE CONTACTLESS DATA-TRANSMITTING DEVICE
DISPOSITIF DE TRANSFERT DE DONNÉES SANS CONTACT, DOCUMENT DE DE SÉCURITÉ ET/OU DE VALEUR LE CONTENANT ET PROCÉDÉ DE RÉALISATION D'UN DISPOSITIF DE TRANSFERT DE DONNÉES SANS CONTACT

(30) Priorität: 01.03.2012 DE 102012203251
(43) Veröffentlichungstag der Anmeldung: 07.01.2015
(73) Patentinhaber: Bundesdruckerei GmbH, 10969 Berlin (DE)
(72) Erfinder: FISCHER, Jörg, 13053 Berlin (DE); MUTH, Oliver, 12277 Berlin (DE); PAESCHKE, Manfred, 16348 Wandlitz (DE); TIETKE, Markus, 12247 Berlin (DE); KLOESER, Joachim, 10779 Berlin (DE); HOLINSKI, Denis, 13055 Berlin (DE); FERBER, Alexander, 12105 Berlin (DE); TRÖLENBERG, Stefan, 15749 Mittenwalde OT Ragow (DE)
(74) Vertreter: Patentanwälte Bressel und Partner mbB
(86) Internationale Anmeldenummer: PCT/EP2013/053731
(87) Internationale Veröffentlichungsnummer: WO 2013/127745

(56) Entgegenhaltungen:
- DE-A1- 10 258 670
- DE-A1-102010 028 444
- US-A1- 2010 182 211

## Beschreibung

Die vorliegende Erfindung betrifft eine kontaktlose Datenübertragungseinrichtung, ein Wert- und/oder Sicherheitsdokument, das eine derartige Datenübertragungseinrichtung enthält, sowie ein Verfahren zur Herstellung der kontaktlosen Datenübertragungseinrichtung.

Derartige kontaktlose Datenübertragungseinrichtungen sind bekannt. Zur Datenspeicherung und/oder Datenverarbeitung beispielsweise in einem Wert- und/oder Sicherheitsdokument werden bereits seit längerer Zeit elektronische Bauelemente in das Dokument integriert, mit denen Daten gespeichert und/oder verarbeitet werden können. Erfindungsgemäß werden unter einem elektronischen Bauelement insbesondere Halbleiterchips verstanden, insbesondere solche, welche zur Speicherung und Verarbeitung von Daten geeignet sind. Insbesondere können die elektronischen Bauelemente elektronische Halbleiterschaltungselemente sein. Die elektronischen Bauelemente umfassen insbesondere sogenannte RFID Chips, welche zur kontaktlosen Kommunikation geeignet sind. RFID-Chips können vergleichsweise einfach z.B. nur eine Seriennummer enthalten und diese bei Aktivierung kontaktlos übermitteln, oder es kann sich um Speicherchips mit Verschlüsselung handeln, wie diese zum Beispiel in elektronischen Reisedokumenten eingesetzt werden. Zur Datenkommunikation mit externen Geräten kann beispielsweise eine Kontaktfeldmatrix mit mehreren Kontaktfeldern gemäß ISO 7816 dienen, die mit dem Chip verbunden sind und die beim Verwenden des Dokuments, beispielsweise einer Karte, über Ein- und Ausgabegeräte einen elektrischen Kontakt zu externen Datenquellen und -speichern herstellen.

Gemäß einer Weiterentwicklung von derartigen Wert- und/oder Sicherheitsdokumenten stehen auch kontaktlose Dokumente zur Verfügung, die ebenfalls elektronische Bauelemente zur Datenspeicherung und -verarbeitung enthalten und die über Ein- und Ausgabegeräte für den Datenaustausch mit externen Datenquellen zusätzlich über eine Antenne verfügen. Daten werden in diesem Falle mittels eines Schreib-/Lesegerätes mit den Bauelementen in dem Dokument dadurch ausgetauscht, dass das Schreib-/Lesegerät ein elektromagnetisches Wechselfeld mit einer Trägerfrequenz typischerweise im Radiowellenbereich erzeugt, das von der Antenne im Dokument detektiert und in elektrische Signale umgewandelt wird, die an das Bauelement weitergeleitet werden. Zur Ausgabe von von dem Dokument ausgehenden Daten erzeugt die Antenne ein entsprechendes elektromagnetisches Wechselfeld, das von dem Schreib-/Lesegerät detektiert wird. Derartige Transponder oder RFID-(radio frequency identification device) Systeme sind ebenfalls seit einiger Zeit bekannt. Eine kontaktlose Kommunikation kann beispielsweise gemäß ISO 14443 erfolgen.

Aus DE 10 2010 028 444 A1 geht ein Dokument mit einem Chip und einer Antenne zur induktiven Einkopplung von Energie hervor. Die Antenne dieses Dokuments weist eine äußere Windung, zumindest eine mittlere Windung und eine innere Windung auf, wobei die mittlere Windung zwischen der äußeren und der inneren Windung angeordnet ist und der Chip mit der äußeren und der inneren Windung in elektrischem Kontakt steht. Die mittlere Windung überbrückt den Chip in einem Überbrückungsbereich der Antenne. Die Antenne ist spiralförmig ausgebildet. Der Chip ist in Flip-Chip-Technik über den Antennenwindungen montiert. Die Antennenwindungen können im Chipbereich eine geringere Breite aufweisen als im übrigen Bereich der Windungen.

In DE 197 32 353 A1 ist eine kontaktlose Chipkarte beschrieben, die einen isolierenden, einstückigen Kartenkörper mit einer Aussparung auf einer Kartenkörperseite, eine elektrisch leitfähige Spule, die direkt auf Oberflächenbereichen der mit wenigstens einer Aussparung versehenen Kartenkörperseite angeordnet ist, sowie einen ungehäusten Chip, der in der Aussparung angeordnet ist, aufweist. Die Chipanschlussflächen des Chips sind mit den Anschlüssen der Spule durch Flip-Chip-Technik elektrisch kontaktiert.

US 6,522,308 B1 gibt eine Kopplungsantenne an, die einen oder mehrere Kondensatoren aufweist und in Form von Windungen auf einem Träger ausgebildet ist. Der Kondensator ist durch eine erste und eine zweite leitfähige Fläche und eine dazwischen liegende isolierende Fläche gebildet. Durch die Zusammenschaltung der Antenne mit dem Kondensator wird ein Resonanzschaltkreis gebildet.

Zur vereinfachten und kostengünstigen Herstellung eines Transponders gibt DE 102 58 670 A1 einen Aufbau mit einer elektronischen Schaltung und einer Antenneneinrichtung an, die wenigstens zwei gemeinsam betreibbare Schwingkreise mit jeweils einer Spule aufweist, die galvanisch voneinander getrennt ausgebildet sind. Einer der Schwingkreise ist mit der elektronischen Schaltung galvanisch verbunden. Der andere Schwingkreis weist einen Kondensator auf. Die beiden Schwingkreise können beispielsweise in verschiedenen Ebenen deckungsgleich übereinander oder auch ineinander geschachtelt angeordnet sein. Vorzugsweise weist jede der Spulen nur eine einzige Windung auf. Die Resonanzfrequenz des Transponders hängt von der Anzahl der Schwingkreise und von den Resonanzfrequenzen ab, die die Schwingkreise jeweils einzeln bei einem voneinander entkoppelten Betrieb aufweisen würden. Sie ist kleiner als die kleinste Resonanzfrequenz der einzelnen Schwingkreise. Es wird angegeben, dass damit die Resonanzfrequenz über die Anzahl und Ausbildung der einzelnen Schwingkreise optimal eingestellt werden kann.

In US 2008/0198078 A1 ist ein Resonanzschaltkreis mit einer Spiralwindungen aufweisenden Antenne eines Resonanzschaltkreises und mit einem Modul mit einem elektronischen Chip beschrieben. Zur Anpassung der Resonanzfrequenz der Antenne weist diese in einer Teilzone Abstände zwischen aufeinander folgenden Spiralwindungen auf, die sich von denen in anderen Teilzonen unterscheiden. Insbesondere können diese Abstände größer als diejenigen in den anderen Teilzonen sein.

In US 2009/0315799 A1 ist ferner eine elektronische Einheit beschrieben, die einen elektronischen Schaltkreis sowie eine damit verbundene Antenne aufweist. Die Antenne weist wiederum eine Schleife auf, die mit dem elektronischen Schaltkreis verbunden ist, sowie einen Resonator, der mit der Schleife gekoppelt ist. Der Resonator ist durch leitfähige Windungen mit freien Enden gebildet. Es wird angegeben, dass die Verwendung des Resonators zum einen die elektrischen Signale verstärkt und zum anderen eine größere Flexibilität hinsichtlich des Designs der Antenne schafft.

In US2010/0182211 A1 ist ein mehrschichtiges Folienelement sowie ein Verfahren zur Herstellung eines solchen Folienelements offenbart.

Die vorstehend angegebenen Transponder erweisen sich allerdings als nachteilig, da der Aufwand bei deren Herstellung relativ hoch ist. Beispielsweise erfordert die Herstellung des Transponders gemäß DE 102 58 670 A1, dass Kondensatoren hergestellt werden müssen. Dies erfordert zusätzliche Arbeitsschritte, die die Kosten erhöhen. Dasselbe gilt auch für die in US 6,522,308 B1 angegebene Antenne. Die in US 2009/0315799 A1 dargestellte Schaltung weist den Nachteil auf, dass die mit der Antennenanordnung erreichbare Resonanzfrequenz sehr hoch ist, sodass eine Abstimmung des Schaltkreises in einen Bereich, der für eine kommerzielle Anwendung in Betracht kommt (im Bereich von 30 kHz bis 30 GHz, bevorzugt 3 bis 30 MHz, beispielsweise 13,56 MHz), nicht möglich oder nur schwierig realisierbar ist.

Von daher besteht das Problem, dass die Herstellung der bekannten Transponder aufwändig ist und dass die Transponder gegebenenfalls nicht ohne weiteres in einem vorgegebenen Frequenzbereich einsetzbar sind. Der vorliegenden Erfindung liegt aus diesem Grunde die technische Aufgabe zugrunde, eine kontaktlose Datenübertragungseinrichtung gemäß ISO 14443 zu schaffen, die einfach und kostengünstig herstellbar und für einen Einsatz in einem vorgegebenen Frequenzbereich einsetzbar ist. Es soll insbesondere auch gewährleistet sein, dass die Datenübertragungseinrichtung durch einfache Maßnahmen auf die vorgegebene Resonanzfrequenz exakt einstellbar/trimmbar ist. Da ein wesentliches Anwendungsgebiet der vorliegenden Erfindung darin besteht, die Datenübertragungseinrichtung auch in Wert- und/oder Sicherheitsdokumenten einzusetzen, muss zudem gewährleistet sein, dass das Dokument nicht manipulierbar ist. Vor allem muss sichergestellt sein, dass ein in dem Dokument enthaltener elektronischer Halbleiterchip nicht entfernt und manipuliert oder durch einen anderen Chip ersetzt werden kann, ohne dass diese Manipulation anschließend erkennbar ist.

Die vorstehenden Aufgaben werden durch die Datenübertragungseinrichtung gemäß Anspruch 1, das Wert- und/oder Sicherheitsdokument gemäß Anspruch 10 und das Verfahren zur Herstellung der kontaktlosen Datenübertragungseinrichtung gemäß Anspruch 11 gelöst. Bevorzugte Ausführungsformen und Weiterbildungen der vorliegenden Erfindung sind in den Unteransprüchen angegeben.

Soweit in der Beschreibung und in den Ansprüchen der vorliegenden Anmeldung der Begriff ,Wert- und/oder Sicherheitsdokument' bzw. 'Sicherheits- und/oder Wertdokument' verwendet wird, ist darunter beispielsweise ein Reisepass, Personalausweis, Führerschein oder eine andere ID-Karte oder ein Zugangskontrollausweis, ein Fahrzeugschein, Fahrzeugbrief, Visum, Scheck, Zahlungsmittel, insbesondere eine Banknote, eine Scheck-, Bank-, Kredit- oder Barzahlungskarte, Kundenkarte, Gesundheitskarte, Chipkarte, ein Firmenausweis, Berechtigungsnachweis, Mitgliedsausweis, Geschenk- oder Einkaufsgutschein, Frachtbrief oder ein sonstiger Berechtigungsnachweis, Steuerzeichen, Postwertzeichen, Ticket, (Spiel-)Jeton, Haftetikett (beispielsweise zur Produktsicherung) oder ein anderes ID-Dokument zu verstehen. Das Wert- und/oder Sicherheitsdokument ist insbesondere eine Smartcard und liegt im ID 1-, ID 2-, ID 3- oder in irgendeinem anderen Format vor, beispielsweise in Heftform, wie bei einem passähnlichen Gegenstand. Ein Wert- und/oder Sicherheitsdokument ist im Allgemeinen ein Laminat aus mehreren Dokumentenlagen, die passergenau unter Wärmeeinwirkung und unter erhöhtem Druck flächig miteinander verbunden sind. Diese Dokumente sollen den normierten Anforderungen genügen, beispielsweise ISO 10373, ISO/IEC 7810, ISO 14443. Die Dokumentenlagen bestehen beispielsweise aus einem Trägermaterial, das sich für eine Lamination eignet. Soweit nachfolgend in der Beschreibung und in den Ansprüchen Begriffe in der Singularform verwendet werden, beispielsweise die Begriffe (elektrisch isolierender) Träger, Trägerlage, Schaltkreiselement, Spiralwindung, Spiralwindungsast, Anschlusskontakt, (elektronisches) Bauelement, Kontaktstelle, Antennen-Leiterzug, Verbindungselement und andere, sind gleichfalls auch deren Pluralbegriffe gemeint, unabhängig von dem Zusammenhang, in dem die Begriffe verwendet werden, sofern nicht ausdrücklich etwas anderes angegeben wird. In umgekehrter Art und Weise kann, sofern solche Begriffe in der Pluralform verwendet werden, an deren Stelle auch die jeweilige Singularform treten, unabhängig von dem Zusammenhang, in dem diese Begriffe verwendet werden, sofern nicht ausdrücklich etwas anderes angegeben wird.

Gemäß einem ersten Aspekt der vorliegenden Erfindung wird eine kontaktlose Datenübertragungseinrichtung geschaffen.

Gemäß einem zweiten Aspekt der vorliegenden Erfindung wird ein Wert- und/oder Sicherheitsdokument geschaffen, das diese kontaktlose Datenübertragungseinrichtung aufweist.

Gemäß einem dritten Aspekt der vorliegenden Erfindung wird ein Verfahren zur Herstellung der kontaktlosen Datenübertragungseinrichtung geschaffen.

Die erfindungsgemäße kontaktlose Datenübertragungseinrichtung kann insbesondere ein Bestandteil des erfindungsgemäßen Wert- und/oder Sicherheitsdokuments, beispielsweise einer Smartcard oder eines Identifikationsdokuments, sein. Beispielsweise kann das Dokument ein Personalausweis, Reisepass, Zugangsausweis, Führerschein, Fahrzeugbrief, Fahrzeugschein, Firmenausweis, Skipass oder ein sonstiger Berechtigungsausweis, ein Ticket im öffentlichen Personen-Nahverkehr, eine Banknote, Kreditkarte, Scheckkarte, Barzahlungskarte, Eintrittskarte, Identifikationskarte, ein Visum oder dergleichen sein. Das Dokument kann in Form einer Karte mit einer Vorderseite und einer Rückseite vorliegen oder als buchartiges Dokument ausgebildet sein. Es kann im Wesentlichen aus Papier oder auch aus Kunststoff hergestellt sein. Im Falle eines Personalausweises trägt dessen Vorderseite zum Beispiel das Lichtbild sowie den Namen des Inhabers. Die Rückseite kann weitere Angaben enthalten, beispielsweise die Anschrift des Inhabers. Das Dokument kann als Transponder, insbesondere als passiver Transponder, beispielsweise als RFID-Sicherheitsdokument, ausgebildet sein.

Das Dokument enthält mindestens ein elektronisches Bauelement, insbesondere ein Halbleiterschaltungselement, auch Chip bezeichnet. Dieses Element wird als Datenverarbeitungssystem in dem Dokument eingesetzt, das beispielsweise eine kryptografische Funktion zur Signierung und/oder Authentifizierung, eine Bezahlfunktion oder eine andere Funktion zur Durchführung einer Finanztransaktion oder eine Ausweisfunktion, insbesondere mit Bildwiedergabe auf einer Anzeigevorrichtung, aufweist.

Das erfindungsgemäße Wert- und/oder Sicherheitsdokument weist mindestens zwei miteinander durch Laminieren verbundene Kunststofflagen auf, wobei eine der Lagen durch die erfindungsgemäße kontaktlose Datenübertragungseinrichtung gebildet und der elektrisch isolierende Träger der Datenübertragungseinrichtung aus Kunststoff hergestellt ist. Alternativ kann das Dokument auch durch Vergießen der elektronischen Komponenten (kontaktlose Datenübertragungseinrichtung mit Chip, Antenne) in Kunststoff hergestellt sein.

Die kontaktlose Datenübertragungseinrichtung weist folgende Komponenten auf, ist aber nicht auf diese beschränkt:
- einen elektrisch isolierenden Träger,
- ein auf dem Träger angeordnetes Schaltkreiselement, das einen durchgehenden Antennen-Leiterzug in Form mindestens einer Spiralwindung, beispielsweise von einer, zwei, drei, vier, fünf, sechs, sieben, acht oder noch mehr Spiralwindungen, und jeweils einen Anschlusskontakt an den Enden des Antennen-Leiterzuges aufweist, und
- ein mit dem Schaltkreiselement elektrisch verbundenes elektronisches Bauelement mit mindestens zwei Kontaktstellen; das elektronische Bauelement ist in seinem jeweiligen Montagebereich über der mindestens einen Spiralwindung platziert; die mindestens zwei Kontaktstellen des Bauelements sind mit jeweils einem Anschlusskontakt des Antennen-Leiterzuges elektrisch verbunden.

Das Schaltkreiselement dient zur induktiven Einkopplung von Energie, die von einem Schreib-/Lesegerät erzeugt wird.

Das elektronische Bauelement und der Antennen-Leiterzug sind vorzugsweise parallel zur Vorder- und Rückseite des Wert- und/oder Sicherheitsdokuments angeordnet, in das die kontaktlose Datenübertragungseinrichtung integriert ist. Der Träger ist als Dokumentenlage in das Dokument integrierbar. Zusätzlich zu dem Träger kann ferner eine Ausgleichslage vorgesehen werden, die auf der Seite des Trägers angeordnet ist, auf der sich auch das elektronische Bauelement befindet, und die eine Aussparung zur Aufnahme des Bauelements aufweist. Die Dicke der Ausgleichslage entspricht vorzugsweise ungefähr der Montagehöhe des Bauelements.

In erfindungsgemäßer Art und Weise verzweigt sich mindestens eine Spiralwindung des Antennen-Leiterzuges außerhalb des Montagebereiches in mindestens zwei, beispielsweise zwei, drei oder vier, Spiralwindungsäste und zwar zwischen jeweils zwei Verzweigungsstellen einer Spiralwindung.

Im Verlauf einer Spiralwindung verzweigt sich diese an einer ersten Verzweigungsstelle beispielsweise in zwei Spiralwindungsäste, und an einer zweiten Verzweigungsstelle werden diese Äste unter Bildung einer einspurigen Spiralwindung wieder zusammengeführt. Dadurch entstehen jeweils zueinander benachbarte Spiralwindungsäste, die gemeinsam eine mehrspurige Spiralwindung bilden. Die Verzweigungsstellen, an denen die Spiralwindungsäste einer Spiralwindung aufeinander treffen, liegen vorzugsweise möglichst weit auseinander, d.h. möglichst dicht beim oder bereits im Montagebereich. Die Verzweigungsstellen können beispielsweise unmittelbar angrenzend an den Montagebereich des elektronischen Bauelements angeordnet sein, sodass die Spiralwindungen im Wesentlichen in ihrem gesamten Verlaufsbereich außerhalb des Montagebereiches mehrspurig verlaufen. Wenn die Spiralwindungen den Montagebereich des Bauelements kreuzen/durchqueren, d.h. das Bauelement überqueren bzw. unterqueren, maximiert eine Aufspaltung der Spiralwindungen an Verzweigungsstellen, die direkt an den Montagebereich des Bauelements angrenzen, die Länge der Aufspaltung der Spiralwindungen in jeweilige Spiralwindungsäste außerhalb des Montagebereichs, indem sich die Spiralwindungsäste praktisch über die gesamte Länge der Spiralwindungsbereiche erstrecken, die außerhalb des Montagebereichs des Bauelements verlaufen. Selbstverständlich können die Spiralwindungen auch in Spiralwindungsbereiche aufgespalten sein, die kürzer als die jeweils außerhalb des Montagebereichs verlaufenden Spiralwindungsbereiche sind. In diesem Falle sind die Verzweigungsstellen nicht jeweils direkt angrenzend an den Montagebereich angeordnet, sondern von diesem beabstandet. Ferner können die Spiralwindungen auch jeweils mehrmals in einem Spiralwindungsbereich zwischen zwei aufeinander folgenden Kreuzungsstellen mit dem Montagebereich in Spiralwindungsäste aufgespalten sein und dazwischen einspurig verlaufen. In letzterem Falle befinden sich jeweils mindestens vier Verzweigungsstellen in den Spiralwindungen zwischen zwei aufeinander folgenden Kreuzungen mit dem Montagebereich. Somit können die Verzweigungsstellen in den Spiralwindungen an mehreren Stellen zwischen zwei aufeinander folgenden Kreuzungsstellen mit dem Montagebereich angeordnet sein. Die Spiralwindungen werden im Montagebereich vorzugsweise nicht in mehreren Spiralwindungsästen sondern in Form jeweils einspuriger, d.h. nicht in Spiralwindungsäste aufgespaltener, Spiralwindungen geführt.

Die Spiralwindungsäste können beispielsweise parallel zueinander verlaufen. Dadurch wird ein umlaufender Strang von Spiralwindungen wie bei einer Spule gebildet. Ganz besonders bevorzugt schmiegen sich benachbarte Spiralwindungen/Spiralwindungsäste möglichst eng aneinander an. Beispielsweise kann der Abstand zwischen zwei benachbarten Spiralwindungen/Spiralwindungsästen weniger als 1 mm, bevorzugt weniger als 500 µm, besonders bevorzugt weniger als 350 µm, betragen. Der Abstand kann ferner mindestens 10 µm, bevorzugt mindestens 50 µm, besonders bevorzugt mindestens 100 µm betragen. Bevorzugt beträgt der Abstand etwa 250 µm. Je geringer der Abstand zwischen den Spiralwindungsästen benachbarter Spiralwindungen ist, desto größer ist die elektrische Kapazität, die durch den Antennen-Leiterzug erzeugt wird. Dadurch kann der Erniedrigung der elektrischen Induktivität durch Aufspaltung der Spiralwindungen in Spiralwindungsäste entgegen gewirkt werden.

Die Aufspaltung der Spiralwindungen in Spiralwindungsäste verändert die elektrischen Eigenschaften des Schaltkreiselements und damit auch die Resonanzfrequenz der Datenübertragungseinrichtung. Mit einer Aufspaltung der Spiralwindungen des Antennen-Leiterzuges verringert sich durch Parallelschaltung von Teilinduktivitäten, die durch die einzelnen Spiralwindungsäste hervorgerufen werden, die Gesamtinduktivität des Schaltkreiselements, sodass die Resonanzfrequenz der Einrichtung erhöht wird. Das Ausmaß dieser Erhöhung hängt von dem Umfang der Aufspaltung (Aufspaltung einer/mehrerer vollständiger Spiralwindungen außerhalb des Montagebereiches oder nur Teilaufspaltung einer oder mehrerer Spiralwindungen, Aufspaltung in zwei, drei oder mehr Spiralwindungsäste), der Position und der Länge der Aufspaltung, der Breite und des Abstandes der Spiralwindungsäste voneinander und natürlich auch von den übrigen Parametern des spiralförmigen Antennen-Leiterzuges, wie der Anzahl der Spiralwindungen, der Form der Spiralwindungen usw. ab. Für eine Anpassung der Resonanzfrequenz der Datenübertragungseinrichtung an einen vorgegebenen Wert wird damit folglich ein zusätzlicher Auslegungsparameter geschaffen, der genutzt werden kann, um das Schaltkreiselement an die Anforderungen des Schreib-/Lesegeräts oder Lesegeräts, das den Transponder anspricht, anzupassen. Anders als bei bekannten Ausführungen von Transponder-Antennenanordnungen kann die Aufspaltung der Spiralwindungen sehr einfach realisiert werden: Im Falle einer drucktechnischen Herstellung der Spiralwindungen des Antennen-Leiterzuges ist lediglich das Layout des Druckbildes für den Antennen-Leiterzug zu verändern. Entsprechendes gilt auch für den Fall, dass der Antennen-Leiterzug mittels eines Ätzverfahrens hergestellt wird. In diesem Falle ist das Layout beispielsweise mittels eines Ätzresists anzupassen. Entsprechendes gilt für vergleichbare Verfahren, wie das Pattern-Plating-Verfahren. Diese Anpassungen sind sehr leicht realisierbar. Anders als bei herkömmlichen Konstruktionen von Antennenanordnungen sind keine zusätzlichen Arbeitsschritte erforderlich, etwa durch das Erzeugen der Leiterstrukturen auf mehreren Ebenen des Trägers oder mehrerer Träger. Darüber hinaus wird auch die Gefahr einer Manipulation eines Wert- und/oder Sicherheitsdokuments, in den die erfindungsgemäße Datenübertragungseinrichtung integriert ist, durch Delaminieren oder anderweitiges Auftrennen der Dokumentenlagen verringert, da die Aufspaltung der Spiralwindungen in jeweils mehrere Spiralwindungsäste ermöglicht, die Breite der Spiralwindungsäste schmaler zu gestalten als die Spiralwindungen in einspuriger Form. Denn für die Auslegung der Spiralwindungen ist unter Einhaltung der Güte der Antenne der Querschnitt der Spiralwindungen maßgeblich, der bei einer Aufspaltung in mehrere Äste durch die Summe der Querschnitte der einzelnen Äste einer Spiralwindung gegeben ist. Wegen der verminderten Breite ist die Haftfestigkeit des Trägers / der Trägerlage der Datenübertragungseinrichtung an einer angrenzenden Dokumentenlage in diesem Falle verbessert, weil die Adhäsion zwischen den Kunststofflagen (der Ausgleichslage, Trägerlage, anderen Dokumentenlagen) größer ist als die Adhäsion zwischen dem Material der Spiralwindungen/Spiralwindungsäste und dem Kunststoff der Dokumentenlagen. Weiter ist auch zu beachten, dass der Querschnitt des Antennen-Leiterzuges einen Einfluss auf dessen elektrischen Widerstand hat. Insbesondere bei Bildung des Antennen-Leiterzuges mit einer Leitpaste oder einem Leitlack wird ein relativ hoher elektrischer Widerstand erhalten, der zu einer Erniedrigung der Ansprechbarkeit des Schaltkreiselements führt. Daher ist der Querschnitt des Leiterzuges (Höhe, Breite) insbesondere in letzterem Falle so groß wie möglich zu wählen.

An den Verzweigungsstellen geht eine einspurige Spiralwindung in die mehrspurige Spiralwindung mit mehreren Spiralwindungsästen über. Dadurch verbreitert sich die Spiralwindung in dem Übergangsbereich lokal. Dieser Übergangsbereich kann sich allmählich verbreiternd ausgebildet sein, etwa trichterförmig, indem die Spiralwindungsäste aus dem einspurigen Spiralwindungsbereich kontinuierlich herausgeführt werden, oder der Übergangsbereich kann stufenförmig ausgebildet sein, indem einer oder mehrere der Spiralwindungsäste aus dem einspurigen Spiralwindungsbereich an einer vorgegebenen Stelle im Verlauf der Spiralwindung stufenförmig herausgeführt wird. In einer weiteren Alternative kann die Verzweigung in Form einer rechtwinkligen Abzweigung erfolgen. Der erstgenannte Fall ist bevorzugt, da der Leiterzug bei mechanischer oder thermischer Belastung weniger stark zu einer Rissbildung neigt, da mechanische Spannungsspitzen vermieden werden.

Der Antennen-Leiterzug weist an dessen Enden jeweils einen Anschlusskontakt auf, der im Montagebereich zur elektrischen Kontaktierung mit dem elektronischen Bauelement dient. Die Anschlusskontakte können aus demselben Material und mit derselben Verfahrenstechnik hergestellt sein wie der Antennen-Leiterzug.

Zur Herstellung der kontaktlosen Datenübertragungseinrichtung wird ein Verfahren mit folgenden Verfahrensschritten vorgesehen:
i) Bereitstellen des Trägers,
ii) Aufdrucken des in Form mindestens einer Spiralwindung ausgebildeten Antennen-Leiterzuges, beispielsweise mittels Siebdruck, Tiefdruck oder Flexodruck, einschließlich der Anschlusskontakte des Antennen-Leiterzuges, vorzugsweise an den Enden der Spiralwindung, auf den Träger, derart dass mindestens eine Spiralwindung vorzgusweise außerhalb des Montagebereiches zwischen jeweils zwei Verzweigungsstellen in mindestens zwei Spiralwindungsäste aufgespalten ist,
iii) Platzieren des elektronischen Bauelements, insbesondere in Flip-Chip-Technik, über dem Antennen-Leiterzug, sodass die Kontaktstellen des elektronischen Bauelements den Anschlusskontakten gegenüber liegen, und mechanisches Befestigen und Kontaktieren des Bauelements mit dem Antennen-Leiterzug.

Im Schritt ii) zeichnen sich die genannten Druckverfahren durch einen verhältnismäßig hohen Farbauftrag aus. Hierdurch werden gedruckte Antennen mit einer vergleichsweise hohen Güte aufgrund eines vergleichsweise geringen elektrischen Widerstandes erreicht. Tiefdruck kann insbesondere in den Formen Stichtiefdruck oder Rastertiefdruck erfolgen. Siebdruck, vorzugsweise in Form von Bogensiebdruck oder Rundsiebdruck, ist das bevorzugte Druckverfahren.

In einer bevorzugten Weiterbildung der vorliegenden Erfindung verläuft die mindestens eine Spiralwindung zwischen mindestens zwei Kontaktstellen des elektronischen Bauelements hindurch, d.h. die Spiralwindungen werden das Bauelement kreuzend unter diesem hindurch bzw. über dieses hinweg geführt. Dies dient dazu, die Enden des Antennen-Leiterzuges mit den Kontaktstellen des Bauelements in Kontakt bringen zu können, ohne dass eine kreuzende Führung einer Spiralwindung über andere Spiralwindungen hinweg bzw. unter anderen hindurch erforderlich wird. Dies führt in einer bevorzugten Weiterbildung der vorliegenden Erfindung zu einer den Strang von Spiralwindungen überbrückenden Anordnung des elektronischen Bauelements. Die einspurigen Spiralwindungen können im Montagebereich des elektronischen Bauelements einen geringeren Abstand untereinander als außerhalb des Montagebereichs aufweisen, um die Windungen zwischen den Kontaktstellen des Bauelements hindurchführen zu können. In diesem Bereich können die Spiralwindungen insbesondere parallel zueinander verlaufen. Um eine vereinfachte Führung der Spiralwindungen zwischen den Kontaktstellen des Bauelements zu ermöglichen, kann es wünschenswert sein, die Anzahl der einspurigen Spiralwindungen auf ein Minimum zu reduzieren. Allerdings wird dieses Ziel damit erkauft, dass die Induktivität der Antenne erniedrigt und damit die Resonanzfrequenz der Datenübertragungseinrichtung erhöht wird, sodass in diesem Falle auf andere Weise eine Anpassung der Resonanzfrequenz an den vorgegebenen Wert erforderlich wird. Beispielsweise kann dies durch eine zusätzliche parallel geschaltete elektrische Kapazität erreicht werden.

In einer weiteren bevorzugten Weiterbildung der vorliegenden Erfindung sind die Spiralwindungsäste des Antennen-Leiterzuges in gleichbleibender Breite verlaufend ausgebildet, beispielsweise in einer Breite von 50 µm bis 2 mm, wobei eine Breite im Bereich von 100 µm bis 350 µm und insbesondere von etwa 200 µm besonders bevorzugt ist. Weiterhin ist es bevorzugt, dass die Spiralwindungsäste des Antennen-Leiterzuges und die im Montagebereich verlaufenden einspurigen Bereiche der Spiralwindungen gleich breit sind. Der Abstand zwischen benachbarten Spiralwindungsästen einer Spiralwindung bleibt über den gesamten Verlauf zwischen zwei Verzweigungsstellen vorzugsweise konstant und beträgt beispielsweise 50 µm bis 2 mm, bevorzugt 100 µm bis 350 µm und ganz besonders bevorzugt etwa 200 µm. In einer besonders bevorzugten Weiterbildung der vorliegenden Erfindung ist der Abstand zwischen allen benachbarten Spiralwindungsästen einer Spiralwindung gleich. Gleichermaßen kann auch der Abstand zwischen benachbarten Spiralwindungen bzw. den Spiralwindungsästen benachbarter Spiralwindungen über den gesamten Verlauf einer Windung konstant gehalten werden. Ganz besonders bevorzugt beträgt der Abstand zwischen den Spiralwindungsästen aller benachbarten Spiralwindungsäste von 50 µm bis 2 mm, bevorzugt 100 µm bis 350 µm und besonders bevorzugt etwa 200 µm.

Diese Weiterbildung der vorliegenden Erfindung hat einen verfahrenstechnischen Vorteil, wenn das Schaltkreiselement mittels Siebdrucktechnik hergestellt wird, die wegen der Zuverlässigkeit und geringen Kosten besonders vorteilhaft ist. Würden die Spiralwindungen/Spiralwindungsäste in diesem Falle nämlich mit variierender Breite hergestellt, so würden sich unter Umständen nicht überall gleich hohe Leiterzugabschnitte ergeben. Dies liegt an den drucktechnischen Bedingungen. Bei der Erzeugung des Antennen-Leiterzuges mit gleichbleibender Breite im gesamten Layout kann dagegen eine gleichbleibende Dicke an allen Stellen des Leiterzuges erreicht werden, sodass auch der Querschnitt und damit der elektrische Widerstand an allen Stellen des Leiterzuges konstant ist. Dies führt zu einer wesentlichen Verbesserung der Qualität des Leiterzuges.

Wenn der Antennen-Leiterzug mit einer Leitpaste oder einem Leitlack gebildet ist, kann der elektrische Widerstand des Leiterzuges durch eine nachträgliche Kompression erniedrigt werden, etwa im Montagebereich des Chips. Dies kann insbesondere durch Ausüben eines Druckes mittels eines Stempels auf den Leiterzug erreicht werden.

In einer weiter bevorzugten Weiterbildung der vorliegenden Erfindung ist das elektronische Bauelement insbesondere ein Halbleiterbauelement (Halbleiterschaltungselement). Das Halbleiterbauelement kann durch einen ungehäusten Halbleiterchip (bare die) gebildet sein. Dies ermöglicht weiter verringerte Kosten bei der Herstellung der erfindungsgemäßen Datenübertragungseinrichtung, da der Chip nicht zunächst in einem Modul montiert werden muss. Alternativ kann das Bauelement aber auch ein gehäustes Bauelement sein, beispielsweise ein Surface Mount Device (SMD) oder ein Chip Scale Package (CSP), oder in einer der folgenden Gehäuseformen: DIP, TQFP, MLF, SOTP, SOT, PLCC, QFN, SSOT, BGA, MOB, oder in anderen üblichen Gehäuseformen vorliegen. Des Weiteren können auch Submodule als Chipträger, basierend auf flexiblen Leiterplatten (Interposa) aus Polyimid, FR4, PC, dünnem Glas, verwendet werden. Das elektronische Bauelement weist mindestens zwei Kontaktstellen auf, die an der Kontaktierungsseite des Bauelements an einander gegenüber liegenden Seiten eines Randes des Elements angeordnet sind.

In einer weiter bevorzugten Weiterbildung der vorliegenden Erfindung ist der Halbleiterchip in der Flip-Chip-Technik auf dem Antennen-Leiterzug montiert. Diese Technik schließt ein, dass der Chip an dessen Kontaktstellen über Kontakthöcker mit nach unten orientierter Kontaktierungsseite des Chips auf den Antennen-Leiterzug montiert (mechanisch und elektrisch verbunden) wird. Hierzu wird typischerweise ein anisotroper Leitkleber verwendet, der den gesamten Raum zwischen der Kontaktierungsseite des Chips und der Seite des Trägers, auf der sich der Antennen-Leiterzug befindet, ausfüllt. Dieser Kleber hat die Eigenschaft, nur in den Bereichen einen elektrischen Kontakt herzustellen, in denen die miteinander in Kontakt zu bringenden Kontaktflächen einander sehr nahe kommen bzw. sich berühren. Durch die Aufbringung von Druck auf die Klebefläche entsteht die Anisotropie der elektrischen Leitfähigkeit. Alternativ kann auch ohne Kleber gearbeitet werden und der Chip unter Druck bei erhöhter Temperatur mit den Anschlusskontakten verbunden werden. Weiter alternativ kann das elektronische Bauelement insbesondere in der Flip-Chip-Technik mittels Lot montiert werden, indem die Kontakthöcker des Chips beispielsweise durch solder bumps gebildet sind (kollabierte Lothöcker). Besonders bevorzugt ist eine Kontaktierung des Chips sowohl mittels eines anisotropen Leitklebers als auch durch ein kollabiertes Lot, das von dem anisotropen Leitkleber umgeben ist. Dies ermöglicht eine sehr gute elektrische Leitfähigkeit und gute mechanische Eigenschaften. Alternativ können die Kontakthöcker auch aus Nickel mit Goldauflage oder aus Palladium gebildet sein. In diesem Falle wird die Chipmontage ausschließlich mittels des anisotropen Leitklebers vorgenommen. Der anisotrope Leitkleber kann beispielsweise mittels eines Dispensers oder durch Aufdrucken auf den Träger bzw. die Spiralwindungen aufgebracht werden.

Für die Montage des elektronischen Bauelements auf dem Antennen-Leiterzug sind die Lage der Kontakthöcker des Bauelements und die Anschlusskontakte des Antennen-Leiterzuges so zueinander anzuordnen, dass sie bei geeigneter Ausrichtung des Bauelements, beispielsweise eines Chips, gegenüber dem Antennen-Leiterzug einander direkt gegenüberstehen und daher einander nahe kommen, d.h. praktisch berühren, können. Diese Montagetechnik ist sehr einfach und zuverlässig durchführbar.

In einer alternativen Ausführungsform der vorliegenden Erfindung kann das elektronische Bauelement in den Träger eingelassen werden, etwa indem eine Aussparung im Träger erzeugt wird, und das Element in diese Aussparung in einer Orientierung, in der die Kontaktierungsseite mit den Kontaktstellen des Bauelements nach oben zeigt, eingeklebt wird, sodass die Kontaktierungsseite mit der Trägeroberfläche fluchtet. Der Antennen-Leiterzug wird anschließend auf der Kontaktierungsseite des Elements und der Trägeroberfläche erzeugt, beispielsweise durch Aufdrucken. Auch in diesem Falle werden die Spiralwindungen des Antennen-Leiterzuges zwischen den Kontaktstellen des elektronischen Bauelements hindurch geführt.

In einer weiteren bevorzugten Weiterbildung der vorliegenden Erfindung sind mindestens zwei der mindestens zwei Spiralwindungsäste mindestens einer Spiralwindung zwischen den Verzweigungsstellen zusätzlich durch jeweils mindestens ein elektrisches Verbindungselement miteinander verbunden. Diese Verbindungselemente können durch Leiterzugabschnitte gebildet sein, die sich zwischen den benachbarten Spiralwindungen/Spiralwindungsästen erstrecken. Sie können an mehreren Stellen zwischen zwei benachbarten Spiralwindungsästen angebracht sein oder nur an einer Stelle. Derartige Verbindungselemente können zwischen Spiralwindungsästen einer Spiralwindung vorgesehen sein oder auch zwischen Spiralwindungsästen mehrerer Spiralwindungen. Sie können in derselben Breite wie die Spiralwindungen/Spiralwindungsäste ausgebildet sein oder schmaler oder breiter sein. Sie können eine gleichbleibende Breite über deren Verbindungslänge haben oder eine variierende Breite. Sie können zunächst durch mehrere, beispielsweise zwei, Abschnitte gebildet werden, die durch einen Spalt voneinander getrennt sind, der zur Anpassung der elektrischen Eigenschaften des Schaltkreiselements nachträglich elektrisch leitend überbrückt wird, sodass ein Verbindungselement entsteht. Alternativ können die elektrischen Verbindungselemente auch zunächst zwischen den benachbarten Spiralwindungsästen durchgehend leitfähig hergestellt werden und dann zum Zwecke einer Anpassung der elektrischen Eigenschaften des Schaltkreiselements bedarfsweise durchtrennt werden. Die Verbindungselemente erhöhen die Induktivität der Antenne des Schaltkreiselements und erniedrigen damit die Resonanzfrequenz der Datenübertragungseinrichtung. Je größer die Anzahl der Verbindungselemente ist, desto größer ist auch die Induktivität.

In einer weiteren bevorzugten Weiterbildung der vorliegenden Erfindung weist das Schaltkreiselement ferner ein kapazitives Schaltungselement auf. Das kapazitive Schaltungselement wird zum Antennen-Leiterzug und damit auch zur Kapazität des elektronischen Bauelements vorzugsweise parallel geschaltet und erniedrigt damit die Resonanzfrequenz der Datenübertragungseinrichtung. Dafür kommt grundsätzlich ein separates Bauelement in Form eines Kondensators in Betracht, mit dem beispielsweise der Träger der Datenübertragungseinrichtung bestückt und der mit dem Antennen-Leiterzug elektrisch verbunden wird. Alternativ kann auch eine Kapazität durch zwei durch ein Dielektrikum getrennte elektrisch leitfähige Flächen auf dem Träger erzeugt werden, beispielsweise durch mehrere Siebdruckschritte. Allerdings sind diese Alternativen aufwändig.

Erfindungsgemäß wird das kapazitive Schaltungselement durch mindestens einen Blind-Leiterzug gebildet, der mit jeweils einem Ende mit einem Anschlusskontakt des Antennen-Leiterzuges elektrisch verbunden ist. Das andere Ende des Blind-Leiterzuges endet als offenes Ende. Dieser Blind-Leiterzug kann wie der Antennen-Leiterzug auf dem Träger und vorzugsweise mit derselben Technik, beispielsweise mittels Siebdruck, gebildet sein.

Diese Blind-Leiterzüge können vorzugsweise, von den Anschlusskontakten des Antennen-Leiterzuges ausgehend, entlang den Spiralwindungen/Spiralwindungsästen des Antennen-Leiterzuges geführt werden. In einem ersten Fall kann ein äußerer Blind-Leiterzug von einem am Antennen-Leiterzug außen liegenden Anschlusskontakt ausgehen und sich parallel zur äußeren Spiralwindung / zum äußeren Spiralwindungsast des Antennen-Leiterzuges fortsetzen. In einem zweiten Fall kann ein innerer Blind-Leiterzug von einem am Antennen-Leiterzug innen liegenden Anschlusskontakt ausgehen und sich parallel zur inneren Spiralwindung / zum inneren Spiralwindungsast des Antennen-Leiterzuges fortsetzen. In einem dritten Fall können sowohl ein derartiger äußerer Blind-Leiterzug als auch ein derartiger innerer Blind-Leiterzug vorgesehen sein.

Der äußere und/oder der innere Blind-Leiterzug können ausschließlich über einen kleineren oder größeren Teil einer Gesamtwindung (etwa 360°) entlang des äußeren bzw. inneren Antennen-Leiterzugteils verlaufen oder mehr als eine Windung, beispielsweise 1,5 Windungen oder zwei oder drei oder noch mehr Windungen, bilden. Der äußere Blind-Leiterzug kann länger sein als der innere Blind-Leiterzug und umgekehrt. Da die Länge der Blind-Leiterzüge durch Parallelschaltung mit dem Antennen-Leiterzug die Kapazität des Schaltkreiselements erhöht und zwar umso mehr je länger diese Leiterzüge ausgebildet sind, besteht eine Möglichkeit der Feinabstimmung der Resonanzfrequenz der Datenübertragungseinrichtung darin, die Länge der Blind-Leiterzüge so einzustellen, dass eine vorgegebene Resonanzfrequenz erreicht wird. Dies kann beispielsweise durch Erzeugen von Blind-Leiterzügen und deren anschließende Kürzung, beispielsweise durch Durchtrennen an geeigneter Stelle, etwa durch Ablation mit einem Laser, mechanisches Entfernen durch Schleifen, Schneiden oder Stanzen, chemisches Auflösen oder Ätzen, geschehen. Diese Feinabstimmung kann beispielsweise bei der Verwendung von verschiedenen Halbleiterchips (elektronischen Bauelementen) mit unterschiedlicher interner Parallelkapazität notwendig werden. Vor allem kann dieser Abstimmungsprozess auch noch nach dem Montieren des elektronischen Bauelements vorgenommen werden, sodass Kapazitätsschwankungen, die auf das Bauelement selbst zurückgeführt werden, ausgeglichen werden können (Trimmen der zusätzlichen Kapazität der Blind-Leiterzüge).

Der äußere und/oder innere Blind-Leiterzug folgen vorzugsweise der Windungsrichtung des Antennen-Leiterzuges, d.h. bei einem von außen nach innen entgegen dem Uhrzeigersinn gewundenen Antennen-Leiterzug ist der innere Blind-Leiterzug, ausgehend von dem inneren Anschlusskontakt, ebenfalls entgegen dem Uhrzeigersinn gewunden, und der äußere Blind-Leiterzug ist in diesem Falle, ausgehend von dem äußeren Anschlusskontakt, im Uhrzeigersinn gewunden. Entsprechendes gilt im umgekehrten Falle. Die Blind-Leiterzüge sind vorzugsweise über ihren gesamten jeweiligen Verlauf gleich breit bleibend ausgebildet. Sie verlaufen vorzugsweise in einem engen Abstand zu den äußeren bzw. inneren Spiralwindungen/Spiralwindungsästen, beispielsweise in einem Abstand von 50 µm bis 2 mm, bevorzugt 100 µm bis 350 µm und besonders bevorzugt in einem Abstand von etwa 200 µm.

Das Schaltkreiselement ist vorzugsweise in einer Ebene des Dokuments gebildet, indem es auf dem Träger erzeugt ist. Dadurch kann das Schaltkreiselement in einem Arbeitsgang erzeugt werden.

In einer weiteren bevorzugten Weiterbildung der vorliegenden Erfindung ist der Antennen-Leiterzug aus einer Leitpaste oder einem Leitlack hergestellt. Diese Technik ist einfach und damit kostengünstig realisierbar. Die Leitpaste oder der Leitlack enthält mindestens ein Polymer als Binder sowie mindestens ein Metall und/oder ein leitfähiges Metalloxid und/oder anderes leitfähiges Material in dem Polymer. Als leitfähiges Material kommen Kupfer, Silber, Gold, Eisen, Zink, Zinn oder Kohlenstoff, insbesondere Graphit, Singlewall- und/oder Multiwall-Nanotubes, Fullerene oder Graphene in Betracht. Als Metalloxide kommen ITO (Indium-ZinnOxid), IZO, FTO (Fluor-dotiertes Zinndioxid), ATO (Antimonoxid) in Betracht, Die Metalle/Metalloxide können in Form von Flakes, Nadeln, Pulver (insbesondere nanoskalig), Plättchen oder dergleichen vorliegen. Insbesondere liegen diese als aggregierte Partikel vor. Als ein anderes leitfähiges Material kommen leitfähige organische Materialien/Polymere, z.B. Polyanilin, PEDOT:PSS, in Betracht. Zur Erzeugung des Schaltkreiselements mit der Leitpaste oder dem Leitlack kann eine Siebdrucktechnik eingesetzt werden, beispielsweise Bogendruck, oder ein Rolle-Rolle-Druckverfahren. Die Dicke der aufgedruckten Paste oder des Lacks kann insbesondere 1 µm bis 100 µm und besonders bevorzugt etwa 10 µm betragen. Die Leitpaste oder der Leitlack kann entweder einfach getrocknet werden oder mittels Wärme und/oder Bestrahlung mit elektromagnetischer Strahlung, beispielsweise UV-Strahlung, aushärtbar sein.

Verwendet werden können die Druckverfahren des Tiefdrucks, insbesondere Stichtiefdruck, auch Intaglio genannt, sowie Rastertiefdruck, Flachdruck, insbesondere Offset, Hochdruck, insbesondere Letterset, Durchdruck, insbesondere Siebdruck, Flexodruck oder Digitaldruckverfahren, insbesondere Inkjet. Bevorzugt sind Siebdruck, Tiefdruck sowie Flexodruck, besonders bevorzugt Siebdruck.

Alternativ kann der Antennen-Leiterzug auch in einer anderen Technik hergestellt sein, beispielweise in einer Ätztechnik aus Aluminium oder Kupfer mittels eines Ätzresists oder in einem Pattern-Plating-Verfahren. Beim Pattern-Plating-Verfahren werden, ausgehend von einer Grundmetallisierung, beispielsweise aus Kupfer, mit einem Platingresist auf der Grundmetallisierung zunächst die Strukturen als Kanäle geformt. Dann wird zusätzliches Metall in den Kanälen galvanotechnisch abgeschieden. Nach dem Entfernen des Platingresists wird die Grundmetallisierung zwischen den Strukturen durch Ätzen entfernt.

In einer weiteren bevorzugten Weiterbildung der vorliegenden Erfindung sind sich zwischen den Spiralwindungsästen befindende Zwischenräume, die durch die Abstände zwischen den Spiralwindungen/Spiralwindungsäste gebildet sind, mit einem dielektrischen Füllmaterial mit einer Dielektrizitätskonstante ausgefüllt, die von derjenigen des Trägers verschieden ist, um die elektrischen Eigenschaften des Schaltkreiselements zu beeinflussen. Beispielsweise kann es vorteilhaft sein, ein Füllmaterial mit einer besonders hohen Dielektrizitätskonstante zu verwenden, beispielsweise eines, das mit Bariumtitanat gefüllt ist. Alternativ kann es auch erwünscht sein, dass das Füllmaterial eine besonders niedrige Dielektrizitätskonstante aufweist. Beispielsweise kommt hierfür ein mit einem fluorierten Polymer gefülltes Füllmaterial in Frage. Die Füllmaterialien sind zumindest zu einem Teil durch einen Binder gebildet, der im Wesentlichen aus demselben Material besteht wie der Träger, um zu gewährleisten, dass das Füllmaterial mit dem Träger- und anderen Dokumentenmaterial eine innige Verbindung eingeht, und um damit zu verhindern, dass das Dokument nach dem Laminieren oder Eingießen nicht aufgetrennt, beispielsweise delaminiert, werden kann. Dieses Material kann beispielsweise durch Aufrakeln oder mittels Siebdruck auf den mit dem Schaltkreiselement versehenen Träger aufgebracht werden. Die damit gebildete Lage kann auch anstelle einer Ausgleichslage für das elektronische Bauelement verwendet werden.

Das Dokument einschließlich des Trägers kann aus einem Polymer, das ausgewählt ist aus einer Gruppe, umfassend Polycarbonat (PC), insbesondere Bisphenol A-Polycarbonat, Polyethylenterephthalat (PET), deren Derivate, wie Glykol-modifiziertes PET (PETG), Polyethylennaphthalat (PEN), Polyvinylchlorid (PVC), Polyvinylbutyral (PVB), Polymethylmethacrylat (PMMA), Polyimid (PI), Polyvinylalkohol (PVA), Polystyrol (PS), Polyvinylphenol (PVP), Polypropylen (PP), Polyethylen (PE), thermoplastische Elastomere (TPE), insbesondere thermoplastisches Polyurethan (TPU), Acrylnitril-Butadien-Styrol-Copolymer (ABS) sowie deren Derivate, und/oder Papier, hergestellt werden. Außerdem kann das Dokument auch aus mehreren dieser Materialien hergestellt sein. Bevorzugt besteht das Dokument aus PC oder PC/TPU/PC. Die Polymere können entweder gefüllt oder ungefüllt vorliegen. Im letzteren Falle sind sie vorzugsweise transparent oder transluzent. Falls die Polymere gefüllt sind, sind sie opak. Das Füllmaterial kann beispielsweise ein Pigment sein oder ein Füllmaterial, das eine besonders hohe oder eine besonders niedrige Dielektrizitätskonstante aufweist. Durch eine geeignete Wahl des Füllmaterials können die elektrischen Eigenschaften des Schaltkreiselements beeinflusst werden. Bevorzugt wird das Dokument aus 3 bis 12, vorzugsweise 4 bis 10 Folien (einschließlich des Trägers der Datenübertragungseinrichtung), hergestellt.

Das Dokument kann aus diesen Materialien insbesondere durch Lamination hergestellt werden. Typischerweise wird die Lamination von PC in einer Laminierpresse bei 170 bis 200 °C und einem Druck von 50 bis 600 N/cm² hergestellt.

Gemäß einer weiteren bevorzugten Weiterbildung der vorliegenden Erfindung ist das erfindungsgemäße Dokument mit einer Anzeigevorrichtung (Display) ausgerüstet. Die Anzeigevorrichtung ist vorzugsweise auf einer anderen Dokumentenlage als dem Träger angeordnet. Diese Vorrichtung kann beispielsweise eine bistabile Anzeigevorrichtung, eine elektrophoretische Anzeigevorrichtung, eine elektrochrome Anzeigevorrichtung, eine Flüssigkristallanzeigevorrichtung (LCD), eine LED-Anzeigevorrichtung, insbesondere anorganische LED- oder organische LED-Anzeigevorrichtung (OLED), eine bistabile LCD-Anzeigevorrichtung, beispielsweise eine twisted nematic, super twisted nematic, cholesterische oder nematische LCD-Anzeigevorrichtung, Drehelementanzeigevorrichtung, Balkenanzeigevorrichtung, Photolumineszenz-Löschungsanzeigevorrichtung oder eine Anzeigevorrichtung auf Basis des Elektrowetting-Effekts oder eine Hybridanzeigevorrichtung sein. Insbesondere kann es sich um eine flexible, bistabile Anzeigevorrichtung handeln. Derartige Anzeigevorrichtungen sind beispielsweise aus US 2006/0250534 A1 bekannt. Weitere bistabile Anzeigevorrichtungen sind beispielsweise aus WO 95/53371 A und EP 1 715 374 A1 bekannt. Bistabile Anzeigevorrichtungen werden auch als "Electronic Paper Display" (EPD) bezeichnet. Das elektronische Bauelement ist zur Ansteuerung der Anzeigevorrichtung ausgebildet. Hierzu kann es einen elektronischen Speicher zur Speicherung von Bilddaten aufweisen, die aufgrund der Einkopplung von elektrischer Energie auf der Anzeigevorrichtung angezeigt werden. Das elektronische Bauelement kann ferner einen internen Treiber für die Anzeigevorrichtung aufweisen, oder es wird mindestens eine zusätzliche externe Komponente, z.B. Treiber, verwendet.

Das elektronische Bauelement und gegebenenfalls die Anzeigevorrichtung können über die Antenne mit Energie versorgt werden (passiver Transponder). Alternativ kann hierfür auch eine separate Antennenanordnung oder eine Batterie vorgesehen sein.

Die Erfindung wird nachfolgend an Hand der Figuren exemplarisch erläutert.
- Fig. 1: zeigt eine Datenübertragungseinrichtung gemäß einer ersten Ausführungsform in einer schematischen Draufsicht;
- Fig. 2: zeigt die Verfahrensschritte zur Herstellung der erfindungsgemäßen Datenübertragungseinrichtung gemäß der ersten Ausführungsform in schematischen Querschnittsansichten; (a) Bereitstellen des Trägers; (b) Aufdrucken des spiralförmigen Antennen-Leiterzuges einschließlich der Anschlusskontakte des Antennen-Leiterzuges auf den Träger; (c) Platzieren des Chips über dem Antennen-Leiterzug;
- Fig. 3: zeigt eine erfindungsgemäße Datenübertragungseinrichtung gemäß einer zweiten Ausführungsform in einer schematischen Draufsicht;
- Fig. 4: zeigt eine erfindungsgemäße Datenübertragungseinrichtung gemäß einer dritten Ausführungsform in einer schematischen Draufsicht;
- Fig. 5: zeigt eine erfindungsgemäße Datenübertragungseinrichtung gemäß einer vierten Ausführungsform in einer schematischen Draufsicht;
- Fig. 6: zeigt eine erfindungsgemäße Datenübertragungseinrichtung gemäß einer fünften Ausführungsform in einer schematischen Draufsicht;
- Fig. 7: zeigt eine erfindungsgemäße Datenübertragungseinrichtung gemäß einer sechsten Ausführungsform in einer schematischen Querschnittsansicht;
- Fig. 8: zeigt ein erfindungsgemäßes Wert- und/oder Sicherheitsdokument mit einer erfindungsgemäßen Datenübertragungseinrichtung und einer Anzeigeeinrichtung in einer perspektivischen Ansicht;
- Fig. 9: zeigt eine erfindungsgemäße Datenübertragungseinrichtung gemäß einer siebten Ausführungsform in einer schematischen Querschnittsansicht.

In den Figuren bezeichnen gleiche Bezugsziffern Elemente mit derselben Funktion.

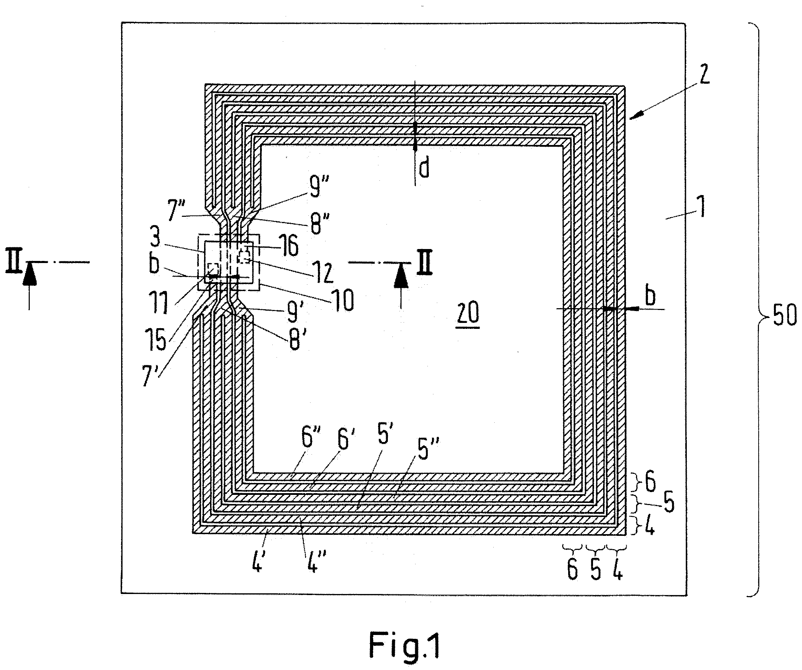

Die kontaktlose Datenübertragungseinrichtung 50 gemäß Fig. 1 besteht aus einem Träger 1, auf dem ein Antennen-Leiterzug 2 und ein elektronisches Bauelement 3, beispielsweise ein ungehäuster Chip, angeordnet sind. Der Chip 3 ist in einem Montagebereich 10 auf dem Träger 1 befestigt. Der Antennen-Leiterzug 2 bildet ein Schaltkreiselement.

Der Träger 1 ist beispielsweise durch eine transparente (ungefüllte) Polycarbonatfolie mit einer Dicke von 80 µm gebildet. Auf der Polycarbonatfolie befindet sich ein durchgehender spiralförmiger Antennen-Leiterzug 2 mit zueinander parallelen Spiralwindungen 4, 5, 6. Jede der Spiralwindungen 4, 5, 6 bildet jeweils vier sich senkrecht zueinander erstreckende Windungsabschnitte, die eine Antenneninnenfläche 20 umschließen. Jede dieser Spiralwindungen 4, 5, 6 ist in jeweils zwei Spiralwindungsäste 4', 4" bzw. 5', 5" bzw. 6', 6" aufgespalten, sodass die Spiralwindungen in diesen Bereichen zweispurig verlaufen. Eine erste Spiralwindung 4 spaltet sich an den Verzweigungsstellen 7', 7" in die Spiralwindungsäste 4', 4", eine zweite Spiralwindung 5 an den Verzweigungsstellen 8', 8" in die Spiralwindungsäste 5', 5" und eine dritte Spiralwindung 6 an den Verzweigungsstellen 9', 9" in die Spiralwindungsäste 6', 6" auf. Im Montagebereich 10 des Chips 3 verlaufen die Spiralwindungen 4, 5, 6 einspurig. Die Spiralwindungen 4, 5, 6 verlaufen außerhalb des Montagebereiches 10 in einem geringen Abstand d parallel zueinander. Dieser Abstand d kann beispielsweise 200 µm betragen. Innerhalb des Montagebereiches 10, d.h. unter dem Chip 3, kann der Abstand zwischen den einspurigen Abschnitten der Spiralwindungen 4, 5, 6 noch geringer sein, weil die Spiralwindungen hier zwischen den Kontaktstellen 11, 12 des Chips 3 hindurchgeführt werden müssen.

Zur elektrischen Kontaktierung des Chips 3 ist dieser in Flip-Chip-Technik auf dem Träger 1 montiert. Hierzu sind dessen Kontaktstellen 11, 12 in Form von Kontakthöckern kongruent zu den Kontaktanschlüssen 15, 16 des Antennen-Leiterzuges 2 ausgebildet, d.h. in einem Abstand, der dem Abstand der Kontaktstellen 11, 12 des Chips 3 entspricht. Der Chip 3 kann beispielsweise mittels eines anisotropen Klebers auf den Träger 1 aufgeklebt sein, um diesen dort mechanisch zu verankern und einen elektrischen Kontakt zwischen den Kontakthöckern 11, 12 und den Kontaktanschlüssen 15, 16 herzustellen.

Der Antennen-Leiterzug 2 geht von einem ersten Kontaktanschluss 15 aus, der mit einem ersten Kontakthöcker 11 des Chips 3 in elektrischem Kontakt steht. Von dort aus erstreckt sich die erste Spiralwindung 4 entgegen dem Uhrzeigersinn über eine erste Verzweigungsstelle 7', an der sich aus der einspurigen ersten Spiralwindung 4 zwei erste Spiralwindungsäste 4', 4", die parallel zueinander verlaufen, bilden. Nach einem Umlauf (360°) vereinigen sich diese beiden ersten Spiralwindungsäste 4', 4" an einer zweiten Verzweigungsstelle 7" wieder miteinander, sodass die erste Spiralwindung 4 wieder einspurig wird. Der Antennen-Leiterzug 2 durchquert dann den Montagebereich 10 des Chips 3 und verläuft hierzu unter dem Chip. Nach dem Verlassen des Montagebereichs 10 verzweigt sich die nunmehr zweite Spiralwindung 5 an der ersten Verzweigungsstelle 8' unter Bildung einer zweispurigen zweiten Spiralwindung, die durch die beiden zweiten Spiralwindungsäste 5', 5" gebildet ist. Diese Äste 5', 5" verlaufen wiederum parallel zueinander und im Gegenuhrzeigersinn parallel zu den ersten Spiralwindungsästen 4', 4" und zwar innerhalb der von diesen gebildeten Antennenfläche 20. Nach einem vollständigen Umlauf der zweiten Spiralwindungsäste 5', 5" vereinigen sich diese an der zweiten Verzweigungsstelle 8" wieder unter Bildung der einspurigen zweiten Spiralwindung 5. Nach dem Durchqueren des Montagebereichs 10 unter dem Chip 3 geht die zweite Spiralwindung 5 in die dritte Spiralwindung 6 über, die sich an der ersten Verzweigungsstelle 9' in zwei dritte Spiralwindungsäste 6', 6" aufspaltet, wobei eine zweispurige dritte Spiralwindung gebildet wird. Nach einem erneuten vollständigen Umlauf innerhalb der durch die ersten Spiralwindungsäste 4', 4" und die zweiten Spiralwindungsäste 5', 5" gebildeten Antennenfläche 20 erreicht die dritte zweispurige Spiralwindung 6 die zweite Verzweigungsstelle 9", wo sich die beiden Äste 6', 6" wieder miteinander vereinigen und die einspurige dritte Spiralwindung 6 bilden. Diese endet im Montagebereich 10 unter dem Chip 3 in einem zweiten Anschlusskontakt 16, der mit einer durch einen Kontakthöcker gebildeten Kontaktstelle 12 des Chips elektrisch kontaktiert ist.

Die Breite b der Spiralwindungsäste 4', 4", 5', 5", 6', 6" ist über deren gesamten Verlauf gleich bleibend und genauso groß wie die Breite der einspurigen Abschnitte der Spiralwindungen 4, 5, 6 im Montagebereich 10 unter dem Chip 3 ausgebildet. Diese Breite b beträgt beispielsweise 250 µm.

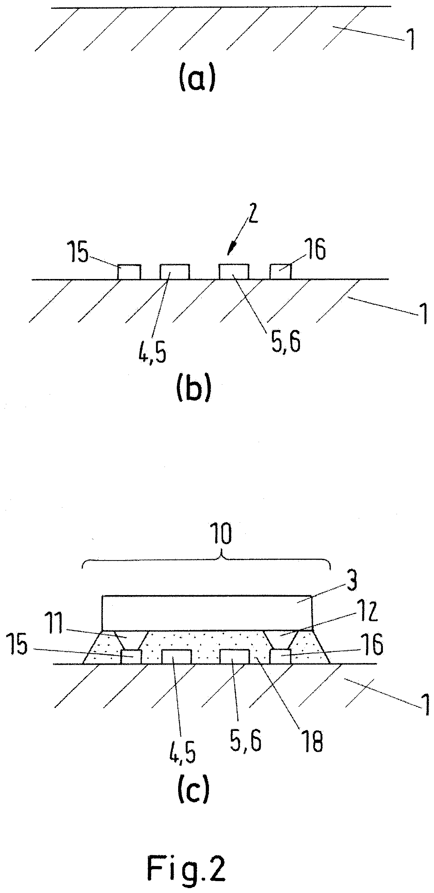

In Fig. 2 ist das Verfahren zur Herstellung der erfindungsgemäßen Datenübertragungseinrichtung 50 von Fig. 1 in einer schematischen Darstellung in Schnitten gemäß II - II (siehe Fig. 1) wiedergegeben.

In einem ersten Verfahrensschritt wird zunächst der Träger 1 bereitgestellt (Fig. 2a). In einem zweiten Verfahrensschritt wird der Antennen-Leiterzug 2, bestehend aus den Spiralwindungen 4, 5, 6 und den Anschlusskontakten 15, 16 auf dem Träger 1 erzeugt, beispielsweise durch Aufdrucken der Antennenstruktur mit einer Silber-Leitpaste mittels Siebdruck (Fig. 2b). In einem dritten Verfahrensschritt wird der Chip 3 montiert. Der Chip 3 weist in Form von Kontakthöckern ausgebildete Kontaktstellen 11, 12 auf, beispielsweise aus Kupfer/Nickel/Gold, die mit den Anschlusskontakten 15, 16 des Antennen-Leiterzuges 2, in elektrischen Kontakt gebracht sind. Hierzu ist der Chip 3 mit den Kontakthöckern 11, 12 auf die Anschlusskontakte 15, 16 aufgesetzt. Für die Chipmontage wird im Montagebereich 10 zunächst ein anisotroper Leitkleber 18 in dosierter Menge beispielsweise mit einem Dispenser auf den Träger 1 und den Antennen-Leiterzug 2 aufgebracht. Dieser Leitkleber 18 enthält sehr kleine leitfähige Metallpartikel, die einen elektrischen Kontakt zwischen den Kontakthöckern 11, 12 des Chips und den Anschlusskontakten 15, 16 herstellen. Außerdem fixiert der Leitkleber 18 den Chip 3 mechanisch auf dem Träger 1.

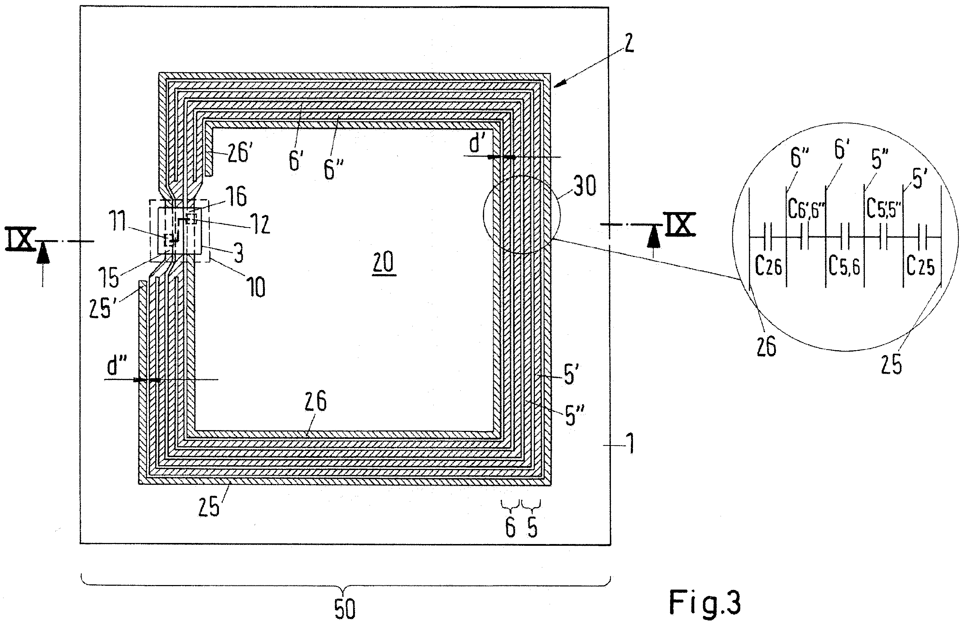

In Fig. 3 ist eine zweite Ausführungsform der erfindungsgemäßen Datenübertragungseinrichtung 50 dargestellt. Diese unterscheidet sich von der in Fig. 1 dargestellten ersten Ausführungsform dadurch, dass der Antennen-Leiterzug 2 zum einen zwei Spiralwindungen 5, 6 anstelle von drei Spiralwindungen aufweist und dass zum anderen zusätzlich zwei Blind-Leiterzüge 25, 26 vorgesehen sind. Der Antennen-Leiterzug 2 und die Blind-Leiterzüge 25, 26 bilden zusammen das Schaltkreiselement der kontaktlosen Datenübertragungseinrichtung 50.

Rechts neben der Darstellung der erfindungsgemäßen Datenübertragungseinrichtung 50 ist ein Ersatzschaltbild für die elektrischen Kapazitäten zwischen den Spiralwindungen 5, 6 und Blind-Leiterzügen 25, 26 wiedergegeben.

Durch die Verringerung der Anzahl von Spiralwindungen 5, 6 des Antennen-Leiterzuges 2 von drei auf zwei wird dessen Induktivität erniedrigt. Dadurch erhöht sich die Resonanzfrequenz der Datenübertragungseinrichtung 50. Um die Resonanzfrequenz wieder auf einen vorgegebenen Wert abzusenken, sind zusätzlich die Blind-Leiterzüge 25, 26 vorgesehen, die zusätzliche Kapazitäten C₂₅, C₂₆ mit dem Antennen-Leiterzug 2 bilden. Ferner sind in dem Ersatzschaltbild auch die Kapazitäten, die sich jeweils zwischen den Spiralwindungen 5, 6 einerseits (C_{5,6}) und zwischen den ersten Spiralwindungsästen (C_{5',5"}) und zweiten Spiralwindungsästen (C_{6',6"}) andererseits bilden, dargestellt. Die Kapazitäten zwischen den jeweiligen Spiralwindungsästen (C_{5',5"}, C_{6',6"}) sind sehr klein. Nicht vernachlässigbar ist jedoch die Kapazität C_{5,6} zwischen den beiden Spiralwindungen 5, 6.

Die Blind-Leiterzüge 25, 26 setzen den Antennen-Leiterzug 2 an den Anschlusskontakten 15, 16 fort und zwar in derselben Windungsrichtung, in der auch der Antennen-Leiterzug 2 gewunden ist. Die Blind-Leiterzüge 25, 26 verlaufen parallel zu den Spiralwindungen 5, 6 und in einem geringen Abstand d', d" zu diesen.

Die Blind-Leiterzüge 25, 26 tragen zur Induktivität des Schaltkreiselements nicht oder nur unwesentlich bei, da sie jeweils in einem freien Ende 25', 26' enden. Durch die Parallelführungen des inneren Blind-Leiterzuges 26 mit der inneren Spiralwindung 6 und des äußeren Blind-Leiterzuges 25 mit der äußeren Spiralwindung 5 werden zusätzliche Kapazitäten C₂₅, C₂₆ gebildet, die zu der Kapazität C₅₅ und der Kapazität des Chips 3 parallel geschaltet sind und daher die Kapazität des Schaltkreiselements insgesamt erhöhen. Dadurch wird die Resonanzfrequenz der Datenübertragungseinrichtung 50 abgesenkt.

Die Blind-Leiterzüge 25, 26 können jeweils kürzer und/oder länger ausgebildet sein als in Fig. 3 gezeigt. Beispielsweise kann der äußere Blind-Leiterzug 25 nicht nur eine Windung ausführen sondern beispielsweise zwei oder noch mehr Windungen. Dasselbe gilt auch für den inneren Blind-Leiterzug 26. Alternativ können der äußere Blind-Leiterzug 25 und/oder der innere Blind-Leiterzug 26 auch jeweils in einer kürzeren Windung bestehen und beispielsweise lediglich eine halbe Windung parallel zum Antennen-Leiterzug 2 ausbilden. Natürlich kann auch einer der beiden Blind-Leiterzüge 25, 26 eine oder mehrere vollständige Windungen ausführen und der andere nur einen Bruchteil einer Windung. Oder ein Blind-Leiterzug oder beide Blind-Leiterzüge 25, 26 können zusätzlich zu einer oder mehreren Windungen noch einen Bruchteil einer weiteren Windung aufweisen. Es hat sich herausgestellt, dass die Ausbildung einer vollständigen ersten Windung des inneren Blind-Leiterzuges 26 zu einer zusätzlichen Erniedrigung der Resonanzfrequenz um beispielsweise 0,5 MHz führt, während die Bildung einer vollständigen ersten Windung des äußeren Blind-Leiterzuges 25 zu einer Erniedrigung der Resonanzfrequenz um beispielsweise 0,25 MHz führt. Jede weitere Windung hat eine geringere Wirkung auf die Absenkung der Resonanzfrequenz. Allerdings hängen die angegebenen Werte dieser jeweiligen Inkremente auch von weiteren Parametern ab.

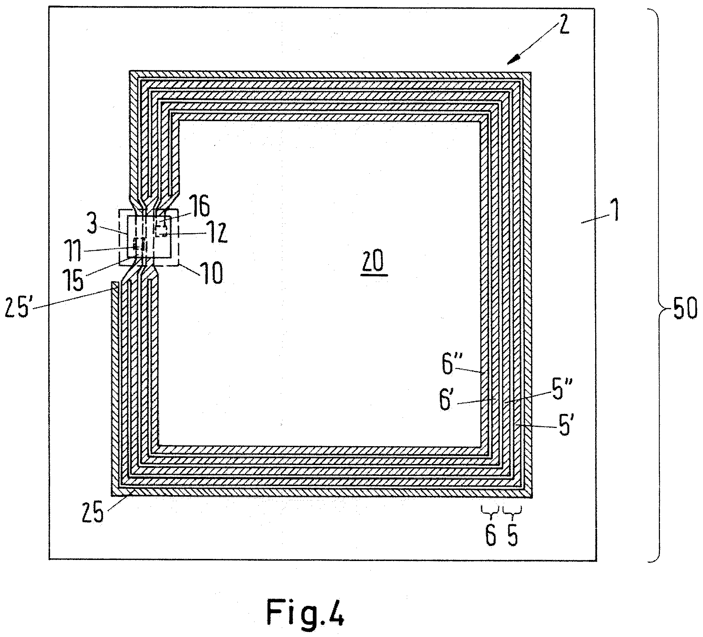

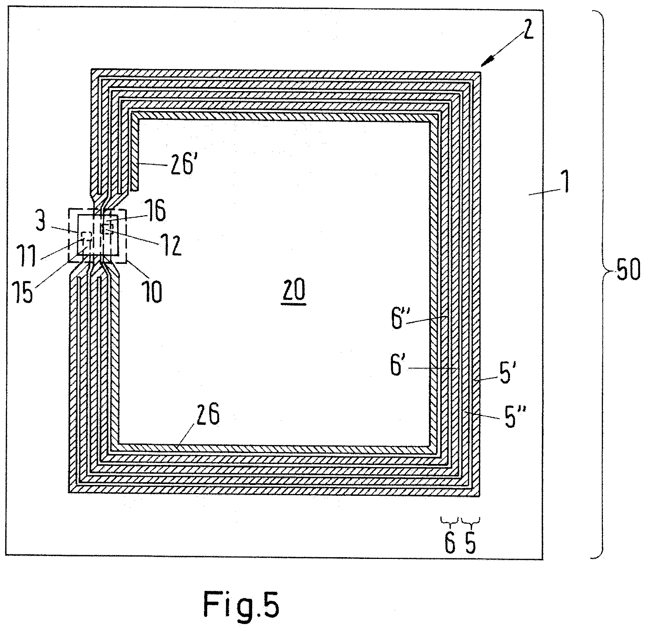

Alternativ zu der in Fig. 3 gezeigten Ausführungsform kann das Schaltkreiselement auch ausschließlich einen äußeren Blind-Leiterzug 25 (Fig. 4; dritte Ausführungsform) oder ausschließlich einen inneren Blind-Leiterzug 26 (Fig. 5, vierte Ausführungsform) aufweisen.

Alternativ können der innere Blind-Leiterzug 26 und/oder der äußere Blind-Leiterzug 25 auch bereits vor dem Einlaufen der jeweiligen Spiralwindungen 5, 6 in den Montagebereich 10 des Chips 3 abgezweigt werden und unter Umgehung des Montagebereiches am Chip vorbei in die entsprechende Blind-Leiterzugbahn geführt werden, die in Fig. 3, 4, 5 gezeigt ist.

Zur Feinjustierung der Gesamtkapazität des Schaltkreiselements kann der kapazitive Beitrag der Blind-Leiterzüge 25, 26 dadurch eingestellt werden, dass deren Länge nachträglich eingestellt wird. Dies ist auch noch dann möglich, wenn der Chip 3 bereits montiert ist, sodass durch den Chip hervorgerufene Schwankungen der Resonanzfrequenz auf diese Weise ausgeglichen werden können. Beispielsweise können die Blind-Leiterzüge 25, 26 zunächst in jeweils einer vorgegebenen Anzahl von Windungen, die parallel zur inneren Spiralwindung 6 bzw. äußeren Spiralwindung 5 verlaufen, erzeugt und dann bedarfsweise gekürzt werden. Dies kann beispielsweise durch Auftrennen der Blind-Leiterzüge 25, 26 an einer geeigneten Stelle, etwa mittels Laserablation, realisiert werden, sodass sich ein kürzerer Blind-Leiterzug ergibt. Alternativ können zunächst auch mehrere untereinander nicht verbundene innere und/oder äußere Blind-Leiterzugabschnitte erzeugt werden, die dann bedarfsweise durch Überbrücken von zwischen den Abschnitten vorhandenen Unterbrechungen miteinander verbunden werden, sodass jeweils Blind-Leiterzüge 25, 26 in der in Fig. 3, 4, 5 gezeigten Anordnung entstehen. Diese Überbrückungen können durch Auftragen eines Leitlackes oder einer Leitpaste auf die Unterbrechungen realisiert werden.

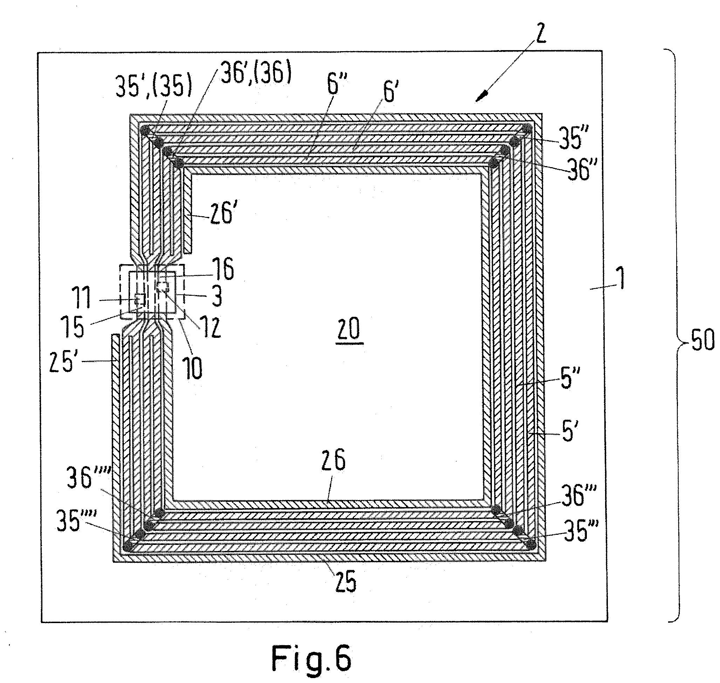

Die in Fig. 6 gezeigte fünfte Ausführungsform einer erfindungsgemäßen Datenübertragungseinrichtung 50 unterscheidet sich von der in Fig. 3 gezeigten dadurch, dass zwischen den Spiralwindungsästen 5', 5" bzw. 6', 6" jeweils zusätzlich mehrere (zwei, drei, vier oder noch mehr) Verbindungselemente 35', 35", 35"', 35"", 36', 36", 36'", 36"" (35, 36) oder alternativ nur jeweils ein Verbindungselement vorgesehen sind. Diese Verbindungselemente 35, 36 schließen die jeweiligen Spiralwindungsäste 5', 5", 6', 6" an den entsprechenden Stellen kurz und führen dazu, dass die Induktivität des Antennen-Leiterzuges 2 erhöht und damit die Resonanzfrequenz des Schaltkreiselements reduziert wird. Die Resonanzfrequenz kann durch Erhöhung der Anzahl der Verbindungselemente 35, 36 reduziert und deren Verringerung erhöht werden. Die Verbindungselemente 35, 36 können auch an anderen Stellen als an den in Fig. 6 angegebenen Stellen vorgesehen sein. Die Verbindungselemente 35, 36 sind vorzugsweise genauso breit wie die Spiralwindungsäste 5', 5", 6', 6".

Alternativ zu der in Fig. 6 gezeigten Ausführungsform können natürlich der äußere und der innere Blind-Leiterzug 25, 26 vollständig oder auch nur einzeln weggelassen werden.

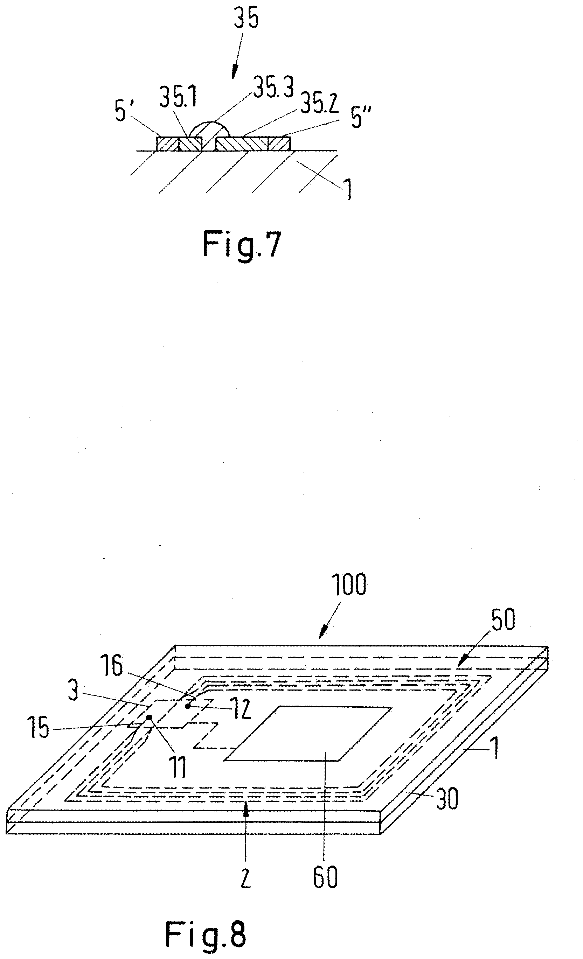

Durch geeignete Anordnung der Verbindungselemente 35, 36 kann damit die Resonanzfrequenz fein justiert werden. Um diese Abstimmung problemlos durchführen zu können, können Verbindungselemente 35, 36 vorgesehen werden, die zunächst durch voneinander getrennte Verbindungselementabschnitte gebildet sind. Zum Trimmen der Resonanzfrequenz können die Unterbrechungen zwischen diesen Abschnitten bedarfsweise mit einer Leitpaste überbrückt werden. Hierzu ist in Fig. 7 ein Beispiel angegeben: Das Verbindungselement 35 zwischen den Spiralwindungsästen 5' und 5" ist zunächst in zwei Abschnitten 35.1 und 35.2 erzeugt worden, beispielsweise durch Siebdruck mit einer Leitpaste. Zum Feinjustieren der Datenübertragungseinrichtung 50 sind diese Abschnitte 35.1, 35.2 durch eine leitfähige Brücke 35.3 miteinander verbunden worden, beispielsweise durch Auftragen eines Leitlackes oder einer Leitpaste auf die Unterbrechung. Alternativ kann ein bestehendes Verbindungselement 35, 36 auch durch Durchtrennen, beispielsweise mittels Laserablation, entfernt werden. Alternativ können die Verbindungselemente 35 auch nachträglich vollständig durch Auftragen einer Leitpaste oder eines Leitlackes erzeugt werden, insbesondere wenn der Abstand zwischen den benachbarten Spiralwindungsästen gering ist.

In Fig. 8 ist ein erfindungsgemäßes Wert- und/oder Sicherheitsdokument 100 in Form einer Karte mit einer erfindungsgemäßen kontaktlosen Datenübertragungseinrichtung 50 in einer perspektivischen Ansicht wiedergegeben. Die Datenübertragungseinrichtung 50 ist durch einen Träger 1, ein Schaltkreiselement, das durch einen Antennen-Leiterzug 2 und gegebenenfalls Blind-Leiterzüge (hier nicht dargestellt) gebildet ist, sowie einen ungehäusten Chip 3 gebildet. Der Chip 3 ist über Kontaktstellen 11, 12 mit den Anschlusskontakten 15, 16 des Antennen-Leiterzuges 2 verbunden. Ferner weist das Dokument 100 ein Anzeigeelement 60 auf, das mit dem Chip 3 verbunden ist. Der Träger 1 mit dem Schaltkreiselement und dem Chip 3 bildet eine von mehreren Dokumentenlagen des Dokuments 100. Diese Dokumentenlagen werden unter erhöhtem Druck und erhöhter Temperatur miteinander laminiert, um einen monolithischen Dokumentenkörper zu bilden. Eine der weiteren Dokumentenlagen ist eine Ausgleichslage 30, die eine Aussparung an der Stelle aufweist, an der der Chip 3 angeordnet ist (nicht dargestellt) und die auf der Seite des Trägers 1 auf diesem angeordnet ist, auf der der Chip montiert ist. Der Träger 1 und die weiteren Dokumentenlagen bestehen vorzugsweise aus demselben Polymer, beispielsweise PC, und sind zum Teil transparent (Overlays) und zum Teil opak, sodass beispielsweise die Datenübertragungseinrichtung 50 von außen nicht sichtbar ist.

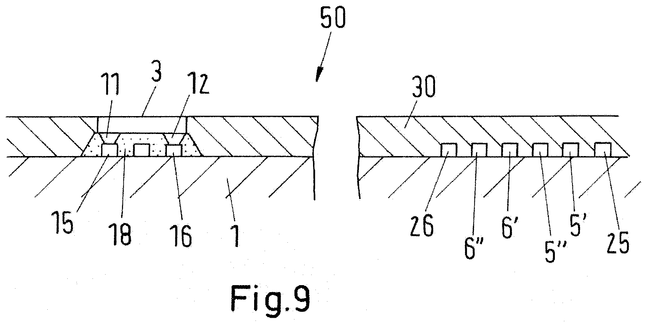

Die in Fig. 9 gezeigte siebte Ausführungsform ist durch einen Querschnitt durch die Datenübertragungseinrichtung 50 von Fig. 3 dargestellt, wobei nach dem Erzeugen des Schaltkreiselements und Montieren des Chips 3 zusätzlich ein Material mit einer hohen Dielektrizitätskonstante auf die Montageseite des Trägers 1 aufgebracht wird. Dieses Material bildet eine Schicht 30, deren Dicke im Wesentlichen der Montagehöhe des Chips 3 entspricht. Diese Schicht kann daher als Ausgleichslage eingesetzt werden. Das Material enthält zur Erhöhung der Dielektrizitätskonstante Bariumtitanat.

## Patentansprüche

1. Kontaktlose Datenübertragungseinrichtung (50), die aufweist:
- einen elektrisch isolierenden Träger (1),
- ein auf dem Träger (1) angeordnetes Schaltkreiselement, das einen durchgehenden Antennen-Leiterzug (2) in Form mindestens einer Spiralwindung (4, 5, 6) und jeweils einen Anschlusskontakt (15, 16) an dessen Enden aufweist, und ein mit dem Schaltkreiselement elektrisch verbundenes elektronisches Bauelement (3) mit mindestens zwei Kontaktstellen (11, 12), wobei das elektronische Bauelement (3) in einem Montagebereich (10) über der mindestens einen Spiralwindung (4, 5, 6) platziert ist und wobei die mindestens zwei Kontaktstellen (11, 12) des elektronischen Bauelements (3) mit jeweils einem Anschlusskontakt (15, 16) des Antennen-Leiterzuges (2) elektrisch verbunden sind,
- wobei sich mindestens eine Spiralwindung (4, 5, 6) außerhalb des Montagebereiches (10) zwischen jeweils zwei Verzweigungsstellen (7', 7"; 8', 8"; 9', 9") in mindestens zwei Spiralwindungsäste (4', 4"; 5', 5"; 6', 6") verzweigt, **dadurch gekennzeichnet, dass** das Schaltkreiselement ferner ein kapazitives Schaltungselement aufweist und dass das kapazitive Schaltungselement durch mindestens einen Blind-Leiterzug (25, 26) gebildet ist, der mit jeweils einem Anschlusskontakt (15, 16) des Antennen-Leiterzuges (2) elektrisch verbunden ist.

2. Kontaktlose Datenübertragungseinrichtung (50) nach Anspruch 1, **dadurch gekennzeichnet, dass** die mindestens eine Spiralwindung (4, 5, 6) zwischen mindestens zwei Kontaktstellen (11, 12) des elektronischen Bauelements (3) hindurch verläuft.

3. Kontaktlose Datenübertragungseinrichtung (50) nach einem der vorstehenden Ansprüche, **dadurch gekennzeichnet, dass** die Spiralwindungsäste (4', 4"; 5', 5"; 6', 6") des Antennen-Leiterzuges (2) in gleichbleibender Breite (b) verlaufend ausgebildet sind.

4. Kontaktlose Datenübertragungseinrichtung (50) nach einem der vorstehenden Ansprüche, **dadurch gekennzeichnet, dass** die Spiralwindungsäste (4', 4"; 5', 5"; 6', 6") des Antennen-Leiterzuges (2) und die im Montagebereich (10) verlaufenden Bereiche der Spiralwindungen (4, 5, 6) gleich breit sind.

5. Kontaktlose Datenübertragungseinrichtung (50) nach einem der vorstehenden Ansprüche, **dadurch gekennzeichnet, dass** das elektronische Bauelement (3) durch einen ungehäusten Halbleiterchip gebildet ist.

6. Kontaktlose Datenübertragungseinrichtung (50) nach Anspruch 5, **dadurch gekennzeichnet, dass** der Halbleiterchip in der Flip-Chip-Technik auf dem Antennen-Leiterzug (2) montiert ist.

7. Kontaktlose Datenübertragungseinrichtung (50) nach einem der vorstehenden Ansprüche, **dadurch gekennzeichnet, dass** mindestens zwei der mindestens zwei Spiralwindungsäste (4', 4"; 5', 5"; 6', 6") mindestens einer Spiralwindung (4, 5, 6) zwischen den Verzweigungsstellen (7', 7"; 8', 8"; 9', 9") zusätzlich durch jeweils mindestens ein elektrisches Verbindungselement (35', 35", 35"', 35""; 36', 36", 36"', 36"") miteinander verbunden sind.

8. Kontaktlose Datenübertragungseinrichtung (50) nach einem der vorstehenden Ansprüche, **dadurch gekennzeichnet, dass** der Antennen-Leiterzug (2) aus einer Leitpaste oder einem Leitlack hergestellt ist.

9. Kontaktlose Datenübertragungseinrichtung (50) nach einem der vorstehenden Ansprüche, **dadurch gekennzeichnet, dass** sich zwischen den Spiralwindungsästen (4', 4"; 5', 5"; 6', 6") befindende Zwischenräume mit einer dielektrischen Substanz mit einer Dielektrizitätskonstante ausgefüllt sind, die von derjenigen des Trägers (1) verschieden ist.

10. Wert- und/oder Sicherheitsdokument, aufweisend mindestens zwei miteinander durch Laminieren verbundene Dokumentenlagen, wobei eine der Lagen durch eine Kontaktlose Datenübertragungseinrichtung (50) nach einem der Ansprüche 1 - 9 gebildet ist.

11. Verfahren zur Herstellung der kontaktlosen Datenübertragungseinrichtung (50) gemäß einem der Ansprüche 1 - 9, umfassend folgende Verfahrensschritte:
i) Bereitstellen eines Trägers (1).
ii) Aufdrucken eines Schaltkreiselements auf den Träger (1), wobei das Schaitkrelseiement einen spiralförmigen Antennen-Leitersug (2) einschließlich Anschlusskontakte (15, 16) des Antennen-Leiterzuges (2) und ein kapazitives Schaltungselement aufweist, wobei das kapazitive Schaltungselement durch mindestens einen Blind-Leiterzug (25, 26) gebildet ist, der mit jeweils einem Anschlusskontakt (15, 16) des Antennen-Leiterzuges (2) elektrisch verbunden ist,
iii) Platzieren eines elektronischen Bauelements (3) über dem Antennen-Letterzug (2), sodass Kontaktstellen (11, 12) des elektronischen Bauelements (3) den Anschlusskontakten (15, 16) gegenüber liegen, und Kontaktieren der Kontaktstellen des elektronischen Bauelements (3) mit den Anschlusskontakten des Antennen-Leiterzuges (2).

## Claims

1. Contactless data transmitting device (50), comprising:
- an electrically insulating substrate (1)
- a circuit element which is arranged on the substrate (1), which consists of a continuous antenna track (2) in the form of at least one spiral winding (4, 5, 6), and a terminal contact (15, 16) at each end of the track, and
- an electronic component (3) which is electrically connected to the circuit element and which comprises at least two contact points (11, 12), wherein the electronic component (3) is placed over the at least one spiral winding (4, 5, 6) in a mounting region (10), and wherein the at least two contact points (11, 12) of the electronic component (3) are electrically connected in each case to a terminal contact (15, 16) of the antenna track (2),
- wherein at least one spiral winding (4, 5, 6) outside the mounting region (10) branches into at least two spiral winding branches (4',4"; 5',5"; 6',6") in each case between two branching points (7',7";8',8"; 9',9"),
- **characterised in that** the circuit element further comprises a capacitative circuit element, and that the capacitative circuit is formed by least one blind track (25, 26), which in each case is electrically connected to a terminal contact (15, 16) of the antenna track (2).

2. Contactless data transmitting device (50) according to claim 1, **characterised in that** the at least one spiral winding (4, 5, 6) runs through between at least two contact points (11, 12) of the electronic component (3).

3. Contactless data transmitting device (50) according to any one of the preceding claims, **characterised in that** the spiral winding branches (4',4"; 5',5"; 6',6") of the antenna track (2) are configured such as to run in a consistent width (b).

4. Contactless data transmitting device (50) according to any one of the preceding claims, **characterised in that** the spiral winding branches (4',4"; 5',5"; 6',6") of the antenna track (2) and the areas of the spiral windings (4, 5, 6) running in the mounting region (10) are of the same width.

5. Contactless data transmitting device (50) according to any one of the preceding claims, **characterised in that** the electronic component (3) is formed by a semiconductor chip without a housing.

6. Contactless data transmitting device (50) according to claim 5, **characterised in that** the semiconductor chip is mounted in the flip-chip technique on the antenna track (2).

7. Contactless data transmitting device (50) according to any one of the preceding claims, **characterised in that** at least two of the at least two spiral winding branches (4',4";5',5";6',6") of at least one spiral winding (4,5,6) between the branching points (7',7";8',8";9',9") are connected to one another in each case by means of at least one electrical connection element (35',35", 35'" 35""; 36', 36", 36'"; 36"").

8. Contactless data transmitting device (50) according to any one of the preceding claims, **characterised in that** antenna track (2) is produced from a conductive paste or a conductive lacquer.

9. Contactless data transmitting device (50) according to any one of the preceding claims, **characterised in that** intermediate spaces between the spiral winding branches (4',4";5',5";6',6") are filled out with a dielectrical substance with a dielectric constant which is different from that of the substrate (1).

10. Value and/or security document, comprising at least two document layers connected to one another by laminating, wherein one of the layers is formed by a contactless data transmitting device (50) according to any one of claims 1-9.

11. Method for producing the Contactless data transmitting device (50) according to any one of claims 1-9, comprising the following method steps:
i) providing a substrate (1)
ii) printing of a circuit element onto the substrate (1), wherein the circuit element comprises a spiral-shaped antenna track (2), including terminal contacts (15, 16) and a capacitative circuit element, wherein the capacitative circuit element is formed by at least one blind track (25, 26), which in each case is electrically connected to a terminal contact (15, 16) of the antenna track (2).
iii) placing of an electronic component (3) over the antenna track (2), such that contact points (11,12) of the electronic element (3) lie opposite the terminal contacts (15,16) and contacting of the contact points of the electronic component (3) with the terminal contacts of the antenna track (2).

## Revendications

1. Dispositif de transfert de données (50) sans contact, qui présente :
- un support (1) électriquement isolant,
- un élément de circuit de commutation disposé sur le support (1), qui présente un conducteur d'antennes (2) continu sous la forme d'au moins un enroulement en spirale (4, 5, 6) et respectivement un contact de raccordement (15, 16) au niveau de ses extrémités, et
- un composant électronique (3) relié électriquement à l'élément de circuit de commutation, avec au moins deux emplacements de contact (11, 12), dans lequel le composant électronique (3) est placé dans une zone de montage (10) au-dessus de l'au moins un enroulement en spirale (4, 5, 6) et dans lequel les au moins deux emplacements de contact (11, 12) du composant électronique (3) sont reliés électriquement à respectivement un contact de raccordement (15, 16) du conducteur d'antennes (2),
- dans lequel au moins un enroulement en spirale (4, 5, 6) se ramifie à l'extérieur de la zone de montage (10) entre respectivement deux emplacements de ramification (7', 7" ; 8', 8" ; 9', 9") en au moins deux branches d'enroulement en spirale (4', 4" ; 5', 5" ; 6", 6"), **caractérisé en ce que** l'élément de circuit de commutation présente en outre un élément de commutation capacitif, et que l'élément de commutation capacitif est formé par au moins un conducteur aveugle (25, 26), qui est relié électriquement à respectivement un contact de raccordement (15, 16) du conducteur d'antennes (2).

2. Dispositif de transfert de données (50) sans contact selon la revendication 1, **caractérisé en ce que** l'au moins un enroulement en spirale (4, 5, 6) s'étend à travers un espace entre au moins deux emplacements de contact (11, 12) du composant électronique (3).

3. Dispositif de transfert de données (50) sans contact selon l'une quelconque des revendications précédentes, **caractérisé en ce que** les branches d'enroulement en spirale (4', 4" ; 5', 5" ; 6', 6") du conducteur d'antennes (2) sont réalisées de manière à s'étendre en une largeur (b) constante.

4. Dispositif de transfert de données (50) sans contact selon l'une quelconque des revendications précédentes, **caractérisé en ce que** les branches d'enroulement en spirale (4', 4" ; 5', 5" ; 6', 6") du conducteur d'antennes (2) et les zones, s'étendant dans la zone de montage (10), des enroulements en spirale (4, 5, 6) présentent une largeur identique.

5. Dispositif de transfert de données (50) sans contact selon l'une quelconque des revendications précédentes, **caractérisé en ce que** le composant électronique (3) est formé par une puce semi-conductrice sans enveloppe.

6. Dispositif de transfert de données (50) sans contact selon la revendication 5, **caractérisé en ce que** la puce semi-conductrice de la technique dite de puce retournée est montée sur le conducteur d'antennes (2).

7. Dispositif de transfert de données (50) sans contact selon l'une quelconque des revendications précédentes, **caractérisé en ce qu'**au moins deux des au moins deux branches d'enroulement en spirale (4', 4" ; 5', 5" ; 6', 6") d'au moins un enroulement en spirale (4, 5, 6) entre les emplacements de ramification (7', 7" ; 8', 8" ; 9', 9") sont reliées les unes aux autres en outre par respectivement au moins un élément de liaison (35', 35", 35'", 35"" ; 36', 36", 36"', 36"") électrique.

8. Dispositif de transfert de données (50) sans contact selon l'une quelconque des revendications précédentes, **caractérisé en ce que** le conducteur d'antennes (2) est fabriqué à partir d'une pâte conductrice ou d'un vernis conducteur.

9. Dispositif de transfert de données (50) selon l'une quelconque des revendications précédentes, **caractérisé en ce que** des espaces intermédiaires se trouvant entre les branches d'enroulement en spirale (4', 4" ; 5', 5" ; 6', 6") sont remplies d'une substance diélectrique avec une constante diélectrique, qui est différente de celle du support (1).

10. Document de valeur et/ou de sécurité, présentant au moins deux couches de document reliées l'une à l'autre par laminage, dans lequel une des couches est formée par un dispositif de transfert de données (50) sans contact selon l'une quelconque des revendications 1 - 9.

11. Procédé servant à fabriquer le dispositif de transfert de données (50) sans contact selon l'une quelconque des revendications 1 - 9, comprenant les étapes de procédé suivantes :
i) fourniture d'un support (1),
ii) application par pression d'un élément de circuit de commutation sur le support (1), dans lequel l'élément de circuit de commutation présente un conducteur d'antennes (2) en forme de spirale, y compris des contacts de raccordement (15, 16) du conducteur d'antennes (2), et un élément de commutation capacitif, dans lequel l'élément de commutation capacitif est formé par au moins un conducteur aveugle (25, 26), qui est relié électriquement à respectivement un contact de raccordement (15, 16) du conducteur d'antennes (2),
iii) placement d'un composant électronique (3) au-dessus du conducteur d'antennes (2) de sorte que des emplacements de contact (11, 12) du composant électronique (3) fassent face aux contacts de raccordement (15, 16), et mise en contact des emplacements de contact du composant électronique (3) avec les contacts de raccordement du conducteur d'antennes (2).
